# EUROPEAN PATENT SPECIFICATION

(11) **EP 3 409 498 B1**
(45) Date of publication and mention of the grant of the patent: **18.03.2020**
(21) Application number: 16897047.3
(22) Date of filing: 28.11.2016
(51) Int. Cl.: B41C 1/10, B41N 1/08, B41N 3/03, G03F 7/11, G03F 7/105, G03F 7/033, G03F 7/00

(54) **LITHOGRAPHIC PRINTING ORIGINAL PLATE FOR ON-PRESS DEVELOPMENT, METHOD FOR PRODUCING LITHOGRAPHIC PRINTING PLATE AND LITHOGRAPHIC PRINTING METHOD**
LITHOGRAFISCHE ORIGINALDRUCKPLATTE FÜR ENTWICKLUNG AUF DER DRUCKPRESSE, VERFAHREN ZUM HERSTELLEN EINER LITHOGRAFISCHEN DRUCKPLATTE UND LITHOGRAFISCHES DRUCKVERFAHREN
PLAQUE ORIGINALE D'IMPRESSION LITHOGRAPHIQUE POUR DÉVELOPPEMENT SUR PRESSE, PROCÉDÉ DE PRODUCTION DE PLAQUE D'IMPRESSION LITHOGRAPHIQUE, ET PROCÉDÉ D'IMPRESSION LITHOGRAPHIQUE

(30) Priority: 30.03.2016 JP 2016067914
(43) Date of publication of application: 05.12.2018
(73) Proprietor: Fujifilm Corporation, Minato-ku Tokyo 106-8620 (JP)
(72) Inventor: TAKANASHI, Genki, Haibara-gun Shizuoka 421-0396 (JP); WATANABE, Noriaki, Haibara-gun Shizuoka 421-0396 (JP)
(74) Representative: Hoffmann Eitle
(86) International application number: PCT/JP2016/085242
(87) International publication number: WO 2017/168831

(56) References cited:
- EP-A1- 2 354 852
- EP-A1- 2 878 452
- JP-A- 2011 175 256
- JP-A- 2013 071 374
- JP-A- 2014 198 453
- US-A1- 2013 052 582

## Description

The present disclosure relates to a planographic printing plate precursor for on-press development, a method of preparing a planographic printing plate, and a planographic printing method.

As a solid-state laser, a semiconductor laser, and a gas laser which emit ultraviolet light, visible light, and infrared light, respectively, having a wavelength of 300 to 1200 nm, small-sized and high-output lasers can be easily obtained in the field of a planographic printing plate precursor, and these lasers are extremely useful as recording light sources during direct plate-making from digital data of a computer and the like. Various researches on recording materials sensitive to various laser beams have been conducted. As representative examples, firstly, a positive type recording material and a negative type recording material are exemplified as materials which can perform recording with an infrared laser having an image recording wavelength of 760 nm or greater. Secondly, a radical polymerization type negative type recording material is exemplified as a recording material compatible with an ultraviolet light laser or a visible light laser having a wavelength of 300 to 700 nm.

In the field of a planographic printing method, a slip mechanism has been provided for a water supply device of a planographic printing press in recent years for the purpose of improving the productivity by reducing the amount of waste paper or shortening the time in print-out, ensuring a uniform water rising property of printing dampening water, and removing dust or paper powder caused by printed paper. As an example, a method of providing a slip mechanism for a water transfer roller may be used. The slip mechanism of a water transfer roller is a mechanism that enables rotation of the water transfer roller at a surface speed different from that of a plate cylinder. In a case where this mechanism works, a slip occurs temporarily between the water transfer roller and the plate cylinder because the water transfer roller and the plate cylinder rotate at different surface speeds.

In a planographic printing plate precursor, it is important to achieve both of printing durability and fouling resistance of a printing plate. For this reason, a planographic printing plate precursor intended to improve both of the printing durability and the fouling resistance by providing a hydrophilic layer having improved adhesiveness to a surface of a support has been known. For example, JP2008-250226A discloses a planographic printing plate precursor which includes a support; a layer containing a compound that contains an ethylenically unsaturated bond and a functional group interacting with a surface of the support, and a polymer compound that contains an ethylenically unsaturated bond, a functional group interacting with a surface of the support, and a hydrophilic functional group; and an image forming layer on the support in this order.

JP2013-205569A discloses a planographic printing plate precursor which includes a support; a layer containing a polymer compound that has a polymer containing a polyfunctional ethylenically unsaturated compound and a polyalkyleneoxy bond in a side chain; and an image forming layer on the support in this order.

JP2004-284223A discloses a planographic printing method including a step of performing a development treatment by rotating a water transfer roller and a plate cylinder at different surface speeds.

Further, JP2010-26006A discloses a plate-making method for a planographic printing plate, including: imagewise-exposing a planographic printing plate precursor which includes an aluminum support that has been subjected to a roughening treatment and an image forming layer containing a radically polymerizable compound containing an infrared absorbing dye, a polymerization initiator, and at least two ethylenically unsaturated groups and an organic polymer compound interacting with an acidic dye, on the aluminum support; and developing the planographic printing plate precursor using an aqueous solution which contains a surfactant and an acidic dye and has a pH of 3 to 10.

Further, US2013052582 discloses a planographic printing plate precursor for on-press development, comprising: an aluminum support; an interlayer which contains a compound containing a hydrophilic group; and an image recording layer which contains an infrared absorbing agent, a polymerization initiator, a polymerizable compound, and polymer particles formed of a styrene copolymer which is a styrene-(meth)acrylonitrile-poly(ethylene glycol)monoalkylether (meth)acrylate compound, on the aluminum support, wherein the aluminum support is an aluminum plate having an anodized film on a surface in contact with the interlayer and the anodized film has micropores extending in a depth direction from a surface in contact with the interlayer, an average pore diameter of the micropores in the surface of the anodized film is in a range of 20 to 40 nm.

An object of embodiments of the present invention is to provide a planographic printing plate precursor for on-press development having excellent printing durability, standing fouling resistance, and on-press developability with time, and a method of preparing a planographic printing plate and a planographic printing method obtained by using the planographic printing plate precursor for on-press development.

The above-described problems of the present invention are solved by means described in the following items: A planographic printing plate precursor for on-press development, comprising: an aluminum support; an interlayer which contains a compound containing a support absorptive group and a hydrophilic group; and an image recording layer which contains an infrared absorbing agent, a polymerization initiator, a polymerizable compound, and polymer particles formed of a styrene copolymer, on the aluminum support, wherein the aluminum support is an aluminum plate having an anodized film on a surface in contact with the interlayer and the anodized film has micropores extending in a depth direction from a surface in contact with the interlayer, an average pore diameter of the micropores in the surface of the anodized film is in a range of 20 to 40 nm, and the styrene copolymer is a copolymer of a styrene-(meth)acrylonitrile-poly(ethylene glycol)monoalkylether (meth)acrylate compound, the hydrophilic group has a structure selected from the group consisting of a betaine structure (zwitterion), a polyalkyleneoxy structure, a sulfonic acid group, a sulfonate group, a carboxylic acid group, and a carboxylate group, and the support absorptive group has a structure selected from the group consisting of a phosphonic acid structure, a phosphonate structure, a phosphoric acid ester structure, and a phosphoric acid ester salt structure.

A method of preparing a planographic printing plate comprising, in order: an exposure step of imagewise-exposing the planographic printing plate precursor for on-press development as mentioned before to form an exposed portion and an unexposed portion; and an on-press development step of supplying at least one of a printing ink or dampening water and removing the unexposed portion.

A planographic printing method comprising, in order: an exposure step of imagewise-exposing the planographic printing plate precursor for on-press development as mentioned before to form an exposed portion and an unexposed portion; an on-press development step of supplying at least one of a printing ink or dampening water and removing the unexposed portion; and a printing step of supplying the printing ink to a planographic printing plate on-press-developed in the on-press development step to print a recording medium.

According to the embodiments of the present invention, it is possible to provide a planographic printing plate precursor for on-press development having excellent printing durability, standing fouling resistance, and on-press developability with time, and a method of preparing a planographic printing plate and a planographic printing method obtained by using the planographic printing plate precursor for on-press development.

Hereinafter, the contents of the present disclosure will be described in detail. In the following only embodiments comprising in combination the features defined in appended claim 1 are embodiments of the present invention. Other embodiments are provided only for reference or comparison. The description of constituent elements below is made based on representative embodiments of the present disclosure in some cases, but the present disclosure is not limited to such embodiments. Further, in the present specification, the numerical ranges shown using "to" indicate ranges including the numerical values described before and after "to" as the lower limit values and the upper limit values.

In the present specification, in a case where substitution or unsubstitution is not noted in regard to the notation of a "group" in a compound, and the "group" may further include a substituent, the group includes not only an unsubstituted group but also a substituent unless otherwise specified. For example, in a chemical structural formula, the description "R represents an alkyl group, an aryl group, or a heterocyclic group" means "R represents an unsubstituted alkyl group, a substituted alkyl group, an unsubstituted aryl group, a substituted aryl group, an unsubstituted heterocyclic group, or a substituted heterocyclic group". Further, in the present specification, "(meth)acrylamide" indicates any one or both of methacrylamide and acrylamide. The same applies to the description of (meth)acrylate or the like. Further, in the present disclosure, "% by mass" has the same definition as that for "% by weight", and "part by mass" has the same definition as that for "part by weight".

Further, in the present disclosure, a combination of two or more preferred aspects is a more preferred aspect.

### (Planographic printing plate precursor for on-press development)

A planographic printing plate precursor for on-press development of the present disclosure (hereinafter, also simply referred to as a "planographic printing plate precursor of the present disclosure") is defined in present claim 1 and includes an aluminum support; an interlayer which contains a compound containing a support absorptive group and a hydrophilic group; and an image recording layer which contains an infrared absorbing agent, a polymerization initiator, a polymerizable compound, and polymer particles formed of a styrene copolymer, on the aluminum support, in which the aluminum support is an aluminum plate having an anodized film on a surface in contact with the interlayer and the anodized film has micropores extending in a depth direction from a surface in contact with the interlayer, and an average pore diameter of the micropores in the surface of the anodized film is in a range of 20 to 40 nm.

As the result of detailed research conducted by the present inventors, it was found that a planographic printing plate precursor for on-press development having an image recording layer on an aluminum support which has been subjected to a phosphoric acid treatment has excellent printing durability, but has a problem in that the pore diameter of micropores in the support which has been subjected to a phosphoric acid treatment is greater than the pore diameter in a case of using other acids and thus an ink is easily fitted in the pores and causes fouling. Particularly, the fouling caused by the ink fitted in the micropores clearly shows as fouling (standing fouling) of a printed material caused at the time of stopping printing after performance of the printing and then performing printing again.

As the result of intensive research conducted by the present inventors, it was found that a planographic printing plate precursor for on-press development having excellent printing durability, standing fouling resistance, and on-press developability with time can be obtained in a case where an interlayer as specified in claim 1 is provided in combination with an image recording layer as specified in claim 1.

In regard to the standing fouling, the detailed mechanism is unclear, but it is speculated that the interlayer remains on a non-image area after development by providing the interlayer which contains a compound containing a support absorptive group and a hydrophilic group so that infiltration of the ink into the micropores is suppressed. Further, in regard to the on-press developability with time, it is speculated that the on-press developability deteriorates since the image recording layer, particularly, some polymer particles in the image recording layer are fitted in the micropores due to the flow of the image recording layer with time. However, it is also speculated that the fitting of the polymer particles is prevented by the interlayer and the deterioration of the on-press developability is prevented by providing the interlayer which contains a compound containing a support absorptive group and a hydrophilic group.

Hereinafter, the support constituting the planographic printing plate precursors of the present disclosure and the constituent layers will be sequentially described, and the method of forming the planographic printing plate precursor of the present disclosure will be described.

### <Aluminum support>

The planographic printing plate precursor of the present disclosure includes an aluminum support. The aluminum support is an aluminum plate having an anodized film on a surface in contact with the interlayer and the anodized film has micropores extending in a depth direction from a surface in contact with the interlayer, and the average pore diameter of the micropores in the surface of the anodized film is in a range of 20 to 40 nm.

In the present disclosure, a hydrophilic treatment may or may not be performed on the surface of the aluminum support. In the planographic printing plate precursor for on-press development of the present disclosure, it is speculated that the hydrophilic surface is formed on the aluminum support because the interlayer remains after on-press development.

As the material of the aluminum support, an alloy containing pure aluminum or aluminum as a main component and a trace amount of foreign elements is exemplified.

Examples of the foreign elements contained in the aluminum alloy include silicon, iron, manganese, copper, magnesium, chromium, zinc, bismuth, nickel, and titanium. The content of the foreign elements in the alloy is preferably 10% by mass or less. In the present disclosure, pure aluminum is preferable. However, since completely pure aluminum is difficult to produce due to the refining technology, aluminum may contain a trace amount of foreign elements. The composition of the aluminum plate is not particularly limited, and known materials of the related art can be used as appropriate.

The thickness of the aluminum support is preferably in a range of 0.1 to 0.6 mm and more preferably in a range of 0.15 to 0.4 mm.

The aluminum support is an aluminum plate having an anodized film on the surface in contact with the interlayer.

As the anodization technology, sulfuric acid anodization and phosphoric acid anodization of an aluminum support are exemplified. The average pore diameter in the film surface of micropores to be formed by the sulfuric acid anodization is typically less than 20 nm while the average pore diameter in the film surface of micropores to be formed by the phosphoric acid anodization is typically 20 nm or greater.

It is preferable that the aluminum support is an aluminum support anodized using phosphoric acid.

The film thickness of the anodized film on the aluminum support is not particularly limited as long as the average pore diameter is in the above-described range, but is preferably in a range of 75 to 2000 nm and more preferably in a range of 85 to 1500 nm.

The average pore diameter of the micropores in the surface of the anodized film is in a range of 20 to 40 nm, preferably in a range of 22 to 38 nm, and more preferably in a range of 25 to 35 nm. In a case where the average pore diameter is in the above-described range, at least the printing durability, the standing fouling resistance, or the on-press developability with time becomes excellent.

Further, in a case where the average pore diameter thereof is less than 20 nm, the printing durability is degraded. In addition, in a case where the average pore diameter thereof is greater than 40 nm, the standing fouling resistance is degraded.

In the present disclosure, a method of measuring the average pore diameter of the micropores in the surface of the anodized film is a method of acquiring an average value by enlarging the surface of the support at a magnification of 150000 using an electron microscope and performing measurement on fifty or more micropores to obtain pore diameters (diameters) of the micropores.

Further, in a case where the shape of the micropores is not circular, an equivalent circle diameter is used. The "equivalent circle diameter" is a diameter of a circle obtained by assuming the shape of an opening portion of a micropore in the surface of the anodized film as a circle having the same projected area as the projected area of the opening portion.

It is preferable that a roughening treatment such as physical polishing, electrochemical polishing, or chemical polishing is performed on the surface of the aluminum support in contact with the interlayer particularly before an anodizing treatment is performed thereon.

Since the final average pore diameter of the micropores in the surface of the anodized film on the aluminum support may be in a range of 20 to 40 nm, the surface roughness of the surface of the support caused by the roughening treatment is not particularly limited, but the average roughness (Ra) is preferably in a range of 0.1 to 0.8 µm and more preferably in a range of 0.1 to 0.6 µm in a case where the roughening treatment is performed.

The back surface (the surface on a side opposite to a side where the interlayer and the image recording layer are provided) of the aluminum support can be provided with a back coat layer containing an organic polymer compound described in JP1993-45885A (JP-H05-45885A) or an alkoxy compound of silicon described in JP1994-35174A (JP-H06-35174A), as necessary.

Further, the back surface of the aluminum support may be provided with at least one layer selected from the group consisting of an antistatic layer, a slip layer, and a matte layer in order to improve the texture and handling of image-formable elements as necessary.

### <Interlayer>

The planographic printing plate precursor of the present disclosure includes an interlayer which contains a compound containing a support absorptive group and a hydrophilic group on the aluminum support as specified in claim 1.

The support absorptive group of the present disclosure indicates a component of the compound contained in the support absorptive group which can remain on the aluminum support even in a development treatment on a printing press because the support absorptive group interacts with the aluminum support. Specific examples thereof include groups and structures described below.

Further, the hydrophilic group of the present disclosure indicates a component which can improve the hydrophilicity of the surface of the aluminum support due to the presence of the compound containing a hydrophilic group on the aluminum support compared to a case where the compound is not present on the aluminum support. Specific examples thereof include groups and structures described below. Moreover, the hydrophilicity of the surface can be evaluated based on the contact angle obtained by a known aerial water drop method.

As the support absorptive group, a structure selected from the group consisting of a phosphonic acid structure, a phosphonate structure, a phosphoric acid ester structure, and a phosphoric acid ester salt structure is used according to the present invention, and a structure selected from the group consisting of a phosphoric acid ester structure and a phosphoric acid ester salt structure is preferable.

As the hydrophilic group, a structure selected from the group consisting of a betaine structure (zwitterion), a polyalkyleneoxy structure, a sulfonic acid group, a sulfonate group, a carboxylic acid group, and a carboxylate group is used according to the present invention, a structure selected from the group consisting of a betaine structure and a polyalkyleneoxy structure is preferable, and a betaine structure is particularly preferable. With the form described above, remaining of the ink on the support is suppressed and the standing fouling resistance becomes excellent.

The compound containing a support absorptive group and a hydrophilic group may be a low molecular weight compound or a high molecular weight compound, and a high molecular weight compound having a weight-average molecular weight of 1000 or greater is preferable. Further, it is preferable that the compound containing a support absorptive group and a hydrophilic group is an addition polymerization type resin.

Further, as the compound containing a support absorptive group and a hydrophilic group, a compound having a structure selected from the group consisting of a phosphonic acid structure, a phosphonate structure, a phosphoric acid ester structure, and a phosphoric acid ester salt structure and a structure selected from the group consisting of a betaine structure and a polyalkyleneoxy structure is preferable, a copolymer which has a constitutional repeating unit having a structure selected from the group consisting of a phosphonic acid structure, a phosphonate structure, a phosphoric acid ester structure, and a phosphoric acid ester salt structure and a constitutional repeating unit having a structure selected from the group consisting of a betaine structure and a polyalkyleneoxy structure is more preferable, and a copolymer which has a constitutional repeating unit having a structure selected from the group consisting of a phosphonic acid structure, a phosphonate structure, a phosphoric acid ester structure, and a phosphoric acid ester salt structure in a side chain and a constitutional repeating unit having a betaine structure and a polyalkyleneoxy structure in a side chain is particularly preferable. With the form described above, the printing durability and the standing fouling resistance become excellent.

Further, in the present disclosure, a "main chain" indicates relatively the longest bonding chain in a molecule of a high molecular weight compound constituting a resin and a "side chain" indicates a bonding chain branched from the main chain.

In the present disclosure, a constitutional repeating unit having a structure selected from the group consisting of a phosphonic acid structure, a phosphonate structure, a phosphoric acid ester structure, and a phosphoric acid ester salt structure is referred to as a constitutional repeating unit A, and a constitutional repeating unit having a structure selected from the group consisting of a betaine structure and a polyalkyleneoxy structure is referred to as a constitutional repeating unit B.

It is preferable that the support absorptive group has a structure represented by Formula A-1 or A-2.

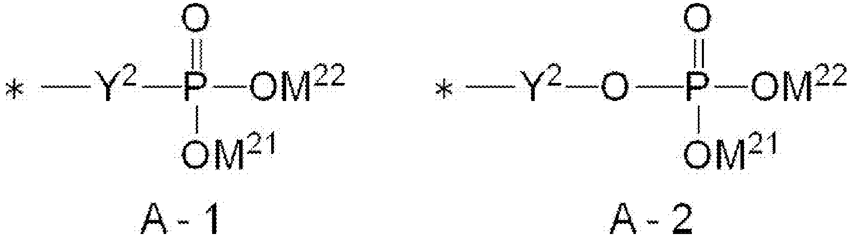

In Formulae A-1 and A-2, M²¹ and M²² each independently represent a hydrogen atom, a metal atom contained in an alkali metal or an alkaline earth metal, or ammonium, Y² represents a single bond or a divalent linking group selected from the group consisting of -CO-, -O-, -NH-, a divalent aliphatic group, a divalent aromatic group, and a combination of these, and the symbol "*" represents a bonding position with respect to another structure.

Specific preferred examples of Y² formed of the above-described combination will be described below. Further, the left side of each example below is bonded to another structure.
L201: -CO-O-divalent aliphatic group-
L202: -CO-O-divalent aromatic group-
L203: -CO-NH-divalent aliphatic group-
L204: -CO-NH-divalent aromatic group-

The divalent aliphatic group as Y² represents an alkylene group, a substituted alkylene group, an alkenylene group, a substituted alkenylene group, an alkynylene group, a substituted alkynylene group, or a polyalkyleneoxy group. Among these, an alkylene group, a substituted alkylene group, an alkenylene group, and a substituted alkenylene group are preferable, and an alkylene group and a substituted alkylene group are more preferable.

As the structure of the divalent aliphatic group, a chain structure is preferable to a cyclic structure, and a linear structure is more preferable to a branched chain structure. The number of carbon atoms of the divalent aliphatic group is preferably in a range of 1 to 20, more preferably in a range of 1 to 15, still more preferably in a range of 1 to 12, particularly preferably in a range of 1 to 10, and most preferably in a range of 1 to 8.

Preferred examples of the substituent in the divalent aliphatic group include a halogen atom (F, Cl, Br, or I), a hydroxy group, a carboxy group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, an arylamino group, and a diarylamino group.

Further, preferred examples of the divalent aromatic group as Y² include a phenylene group, a substituted phenylene group, a naphthalene group, and a substituted naphthalene group. Among these, a phenylene group is more preferable.

Preferred examples of the substituent in the divalent aromatic group include an alkyl group and those exemplified as substituents in the divalent aliphatic group.

Specific preferred examples of Formulae A-1 and A-2 include the following structures. It is needless to say that the present disclosure is not limited to the following structure. In the formulae, M's each independently represent a hydrogen atom or an alkali metal, and the symbol "*" represents a bonding position with respect to another structure.

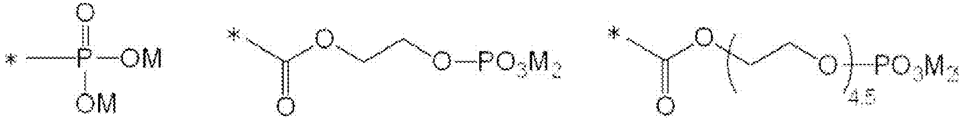

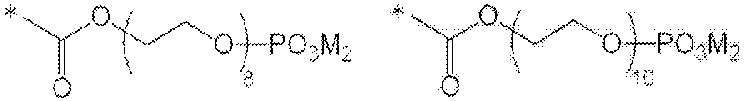

From the viewpoints of the printing durability, the standing fouling resistance, and the developability, the content of the constitutional repeating unit A in the compound containing a support absorptive group and a hydrophilic group used in the present disclosure is preferably in a range of 1% to 40% by mass, more preferably in a range of 3% to 30% by mass, and particularly preferably in a range of 5% to 20% by mass with respect to the total mass of the above-described compound.

As the betaine structure in the hydrophilic group, a structure represented by Formula B-1 or B-2 is preferable and a structure represented by Formula B-1 is more preferable.

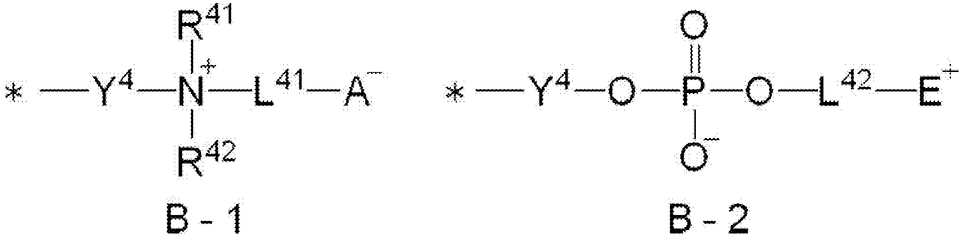

In Formulae B-1 and B-2, R⁴¹ and R⁴² each independently represent a hydrogen atom, an alkyl group, an alkenyl group, an alkynyl group, an aryl group, or a heterocyclic group, and R⁴¹ and R⁴² may be linked to each other to form a ring structure. L⁴¹ and L⁴² represent a divalent linking group, A⁻ represents a group having an anion, E⁺ represents a group having a cation, Y⁴ represents a divalent linking group, and the symbol "*" represents a bonding position with respect to another structure.

First, Formula B-1 will be described. In Formula B-1, the number of carbon atoms of the alkyl group, the alkenyl group, the alkynyl group, the aryl group, or the heterocyclic group as R⁴¹ and R⁴², including the number of carbon atoms of the substituent described below, is preferably in a range of 1 to 30, more preferably in a range of 1 to 20, still more preferably in a range of 1 to 15, and particularly preferably in a range of 1 to 8.

The ring structure which may be formed by R⁴¹ and R⁴² being linked to each other may have heteroatoms such as an oxygen atom, is preferably a 5- to 10-membered ring, and more preferably a 5- or 6-membered ring.

In a case where R⁴¹ and R⁴² represent an alkyl group, preferred examples thereof include a methyl group, an ethyl group, a propyl group, an octyl group, an isopropyl group, a t-butyl group, an isopentyl group, a 2-ethylhexyl group, a 2-methylhexyl group, and a cyclopentyl group.

In a case where R⁴¹ and R⁴² represent an alkenyl group, preferred examples thereof include a vinyl group, an allyl group, a prenyl group, a geranyl group, and an oleyl group.

In a case where R⁴¹ and R⁴² represent an alkynyl group, preferred examples thereof include an ethynyl group, a propargyl group, and a trimethylsilylethynyl group.

In a case where R⁴¹ and R⁴² represent an aryl group, preferred examples thereof include a phenyl group, a 1-naphthyl group, and a 2-naphthyl group.

In a case where R⁴¹ and R⁴² represent a heterocyclic group, preferred examples thereof include a furanyl group, a thiophenyl group, and a pyridinyl group.

R⁴¹ and R⁴² may further include a substituent, and preferred examples of the substituent include a halogen atom (F, Cl, Br, or I), a hydroxy group, a carboxy group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group, and a diarylamino group.

From the viewpoints of the effects and availability, it is particularly preferable that R⁴¹ and R⁴² each independently represent a hydrogen atom, a methyl group, or an ethyl group.

In Formula B-1, as the divalent linking group represented by Y⁴, a single bond or a divalent linking group selected from the group consisting of -CO-, -O-, -NH-, a divalent aliphatic group, a divalent aromatic group, and a combination of these is preferable, and a single bond, -CO-, a divalent aliphatic group, a divalent aromatic group, L401: -CO-O-divalent aliphatic group-, L402: -CO-O-divalent aromatic group-, L403: -CO-NH-divalent aliphatic group-, or L404: -CO-NH-divalent aromatic group- is more preferable. From the viewpoint of fouling resistance, Y⁴ represents more preferably L404 or L403 and particularly preferably L403. Further, the divalent aliphatic group as L403 is preferably a linear alkylene group having 2 to 4 carbon atoms and more preferably a linear alkylene group having 3 carbon atoms from the viewpoint of the synthesis.

In Formula B-1, it is preferable that L⁴¹ represents a linking group selected from -CO-, -O-, -NH-, a divalent aliphatic group, a divalent aromatic group, and a combination of these, and the number of carbon atoms of the linking group, including the carbon atoms of the substituent described below, is more preferably 30 or less. Specific examples thereof include an alkylene group (having preferably 1 to 20 carbon atoms and more preferably 1 to 10 carbon atoms) and an arylene group (having preferably 6 to 15 carbon atoms and more preferably 6 to 10 carbon atoms) such as phenylene or xylylene. Among these, from the viewpoint of the fouling resistance, L⁴¹ represents preferably a linear alkylene group having 3 to 5 carbon atoms, more preferably a linear alkylene group having 4 or 5 carbon atoms, and particularly preferably a linear alkylene group having 4 carbon atoms.

In Formula B-1, it is preferable that A⁻ represents a carboxylate, a sulfonate, a phosphate, a phosphonate, or a phosphinate.

Specific preferred examples thereof include groups having anion structures described below.

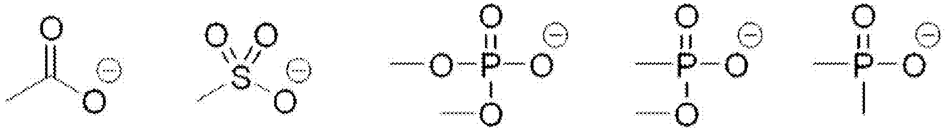

From the viewpoint of the fouling resistance, it is particularly preferable that A⁻ represents a sulfonate.

In Formula B-1, a combination of a linear alkylene group having 4 or 5 carbon atoms as L⁴¹ and a sulfonate as A⁻ is preferable, and a combination of a linear alkylene group having 4 carbon atoms as L⁴¹ and a sulfonate as A⁻ is more preferable.

Further, in Formula B-1, a combination in which Y⁴ represents L401 or L403, R⁴¹ and R⁴² each independently represent a methyl group or an ethyl group, L⁴¹ represents a linear alkylene group having 4 or 5 carbon atoms, and A⁻ represents a sulfonate is preferable, and a combination of L403 as Y⁴, a methyl group as R⁴¹ and R⁴², a linear alkylene group having 4 carbon atoms as L⁴¹, and a sulfonate as A⁻ is more preferable.

Specific preferred examples of the betaine structure represented by Formula B-1 include the following structures. In the formulae, the symbol "*" represents a bonding position with respect to another structure, and a bonding position with respect to the main chain of a high molecular weight compound is preferable.

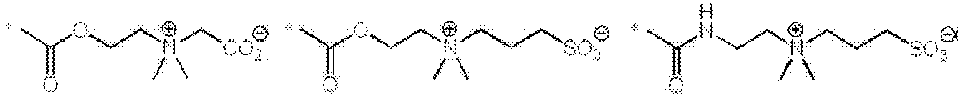

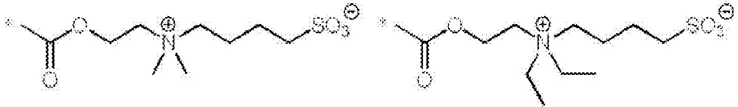

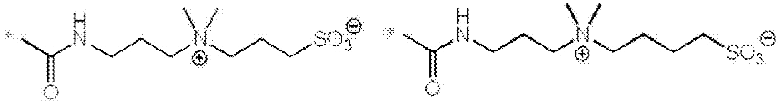

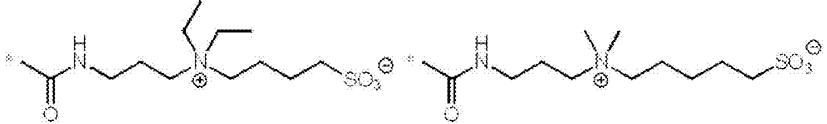

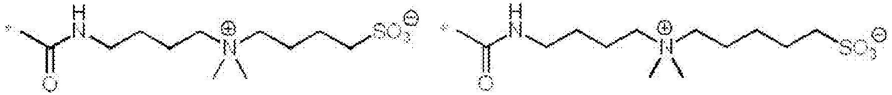

Next, the betaine structure represented by Formula B-2 will be described.

L⁴² in Formula B-2 has the same definition as that for L⁴¹ in Formula B-1, and the preferable aspects thereof are the same as described above.

Y⁴ in Formula B-2 has the same definition as that for Y⁴ in Formula B-1, and the preferable aspects thereof are the same as described above.

E⁺ represents preferably a structure having ammonium, phosphonium, iodonium, or sulfonium, more preferably a structure having ammonium or phosphonium, and particularly preferably a structure having ammonium.

Specific preferred examples of E⁺ include a trimethylammonio group, a triethylammonio group, a tributylammonio group, a benzyldimethylammonio group, a diethylhexylammonio group, a (2-hydroxyethyl)dimethylammonio group, a pyridinio group, a N-methylimidazolio group, a N-acridinio group, a trimethylphosphonio group, a triethylphosphonio group, and a triphenylphosphonio group.

The most preferable combination of L⁴², Y⁴, and E⁺ in Formula B-2 is a combination of an alkylene group having 2 to 4 carbon atoms as L⁴², L401 or L403 as Y⁴, and a trimethylammonio group or a triethylammonio group as E⁺.

Specific preferred examples of the betaine structure represented by Formula B-2 include the following structures. In the formulae, the symbol "*" represents a bonding position with respect to another structure, and a bonding position with respect to the main chain of a high molecular weight compound is preferable. Further, Et represents an ethyl group.

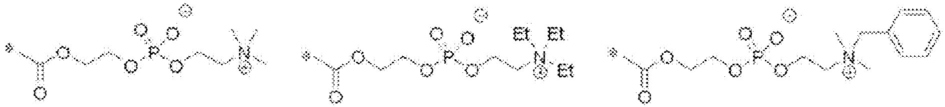

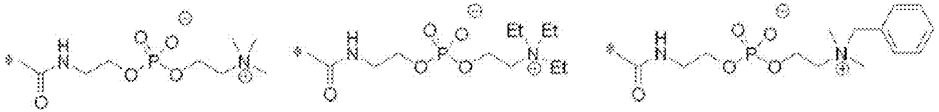

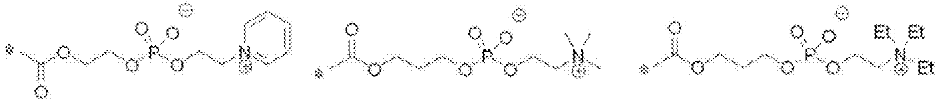

From the viewpoints of the standing fouling resistance and the developability, the content of the constitutional repeating unit B in the compound containing a support absorptive group and a hydrophilic group used in the present disclosure is preferably in a range of 30% to 95% by mass, more preferably in a range of 40% to 90% by mass, and still more preferably in a range of 50% to 85% by mass with respect to the total mass of the compound.

The compound containing a support absorptive group and a hydrophilic group further contains preferably a polymerizable group, more preferably an ethylenically unsaturated group, still more preferably a constitutional repeating unit containing an ethylenically unsaturated group (also referred to as a "constitutional repeating unit C"), and particularly preferably a constitutional repeating unit containing an ethylenically unsaturated group in a side chain.

The compound containing a support absorptive group and a hydrophilic group has preferably a structure represented by any of Formulae C-1 to C-3 and more preferably a constitutional repeating unit having a structure represented by any of Formulae C-1 to C-3, as the structure having an ethylenically unsaturated group.

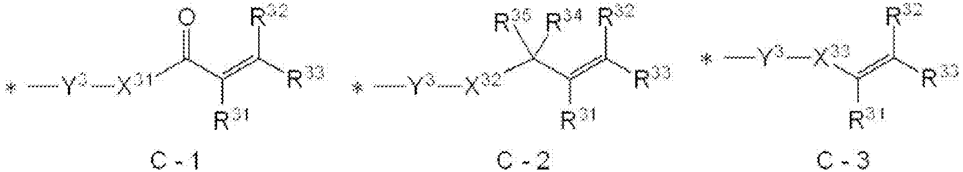

In Formulae C-1 to C-3, X³¹ and X³² represent an oxygen atom, a sulfur atom, or -N(R³⁶)-, X³³ represents an oxygen atom, a sulfur atom, -N(R³⁷)-, or a phenylene group, Y³ represents a single bond or a divalent linking group selected from the group consisting of -CO-, -O-, -NH-, a divalent aliphatic group, a divalent aromatic group, and a combination of these, R³¹ to R³⁷ each independently represent a monovalent substituent, and the symbol "*" represents a bonding position with respect to another structure.

In Formulae C-1 to C-3, X³¹ and X³² represent an oxygen atom, a sulfur atom, or -N(R³⁶)- and preferably an oxygen atom or -N(R³⁶)-. It is preferable that X³³ represents an oxygen atom or -N(R³⁷)-.

Specific preferred examples of the divalent linking group which is a combination of -CO-, -O-, -NH-, a divalent aliphatic group, or a divalent aromatic group as Y³ in Formulae C-1 to C-3 are described below. Further, the left side of each example below is a position bonded to another structure.
L301: -CO-O-divalent aliphatic group-
L302: -CO-O-divalent aromatic group-
L303: -CO-NH-divalent aliphatic group-
L304: -CO-NH-divalent aromatic group-
L305: -CO-O-divalent aliphatic group-O-CO-NH-divalent aliphatic group-
L306: -CO-O-divalent aliphatic group-O-CO-NH-divalent aromatic group-
L307: -CO-O-divalent aromatic group-O-CO-NH-divalent aliphatic group-
L308: -CO-O-divalent aromatic group-O-CO-NH-divalent aromatic group-
L309: -CO-NH-divalent aliphatic group-NH-CO-NH-divalent aliphatic group-
L310: -CO-NH-divalent aliphatic group-NH-CO-NH-divalent aromatic group-
L311: -CO-NH-divalent aromatic group-NH-CO-NH-divalent aliphatic group-
L312: -CO-NH-divalent aromatic group-NH-CO-NH-divalent aromatic group-
[0051] The divalent aliphatic group in L301 to L312 has the same definition as that for the divalent aliphatic group in L201 to L204, and the preferable aspects are the same as described above. Further, the divalent aromatic group in L301 to L312 has the same definition as that for the divalent aromatic group in L201 to L204, and the preferable aspects are the same as described above.

In Formulae C-1 to C-3, it is preferable that Y³ represents a single bond, -CO-, a divalent aliphatic group, a divalent aromatic group, or L301 to L312. From the viewpoint of the fouling resistance, it is more preferable that Y³ represents L301, L303, L305, or L309. Further, it is still more preferable that a divalent aliphatic group as L301, L303, L305, or L309 is a divalent linking group having 1 to 10 carbon atoms, to which an alkylene group having 1 to 10 carbon atoms or an alkylene group 2 or more carbon atoms is linked through an oxygen atom linking group (here, the alkylene groups may each independently include a substituent). It is particularly preferable that the divalent linking group to which the alkylene group having 2 or more carbon atoms is linked through an oxygen atom linking group is an ethylene oxide chain, a propylene oxide chain, or a combination of these.

In the structures represented by any of Formulae C-1 to C-3, from the viewpoints of the fouling resistance and the printing durability, it is preferable that the structure containing an ethylenically unsaturated group is a structure represented by Formula C-1.

Specific preferred examples of Formulae C-1 to C-3 include the following structures. It is needless to say that the present disclosure is not limited to the following structure. In the formulae, the symbol "*" represents a bonding position with respect to another structure, and a bonding position with respect to the main chain of a high molecular weight compound is preferable.

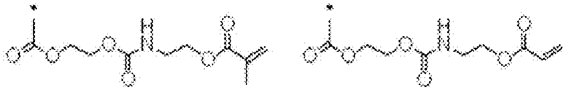

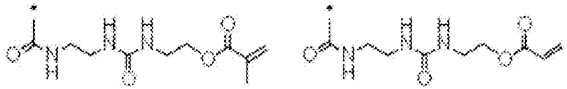

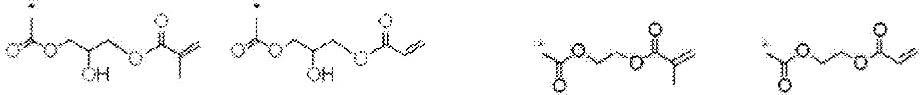

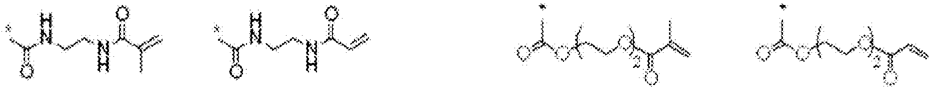

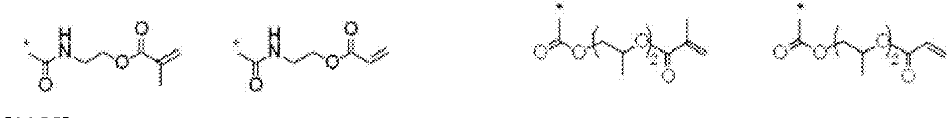

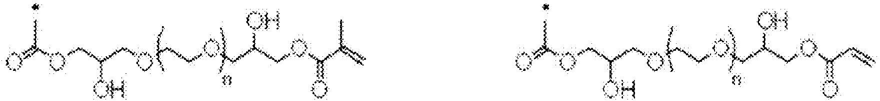

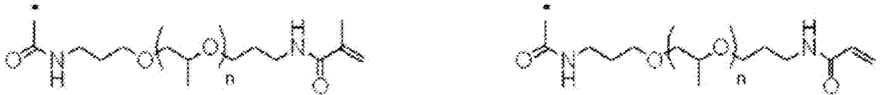

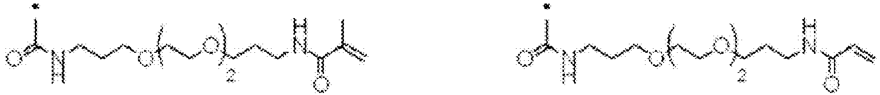

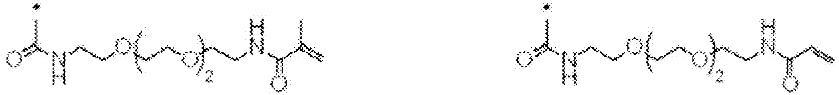

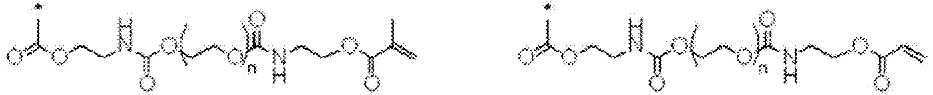

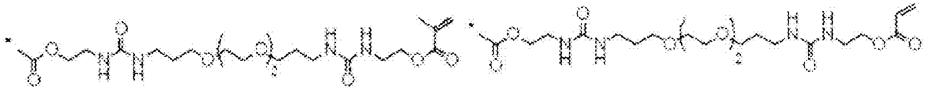

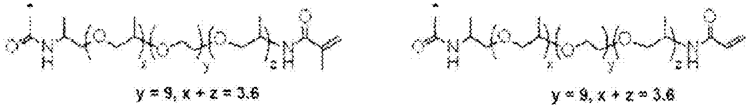

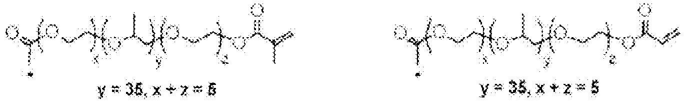

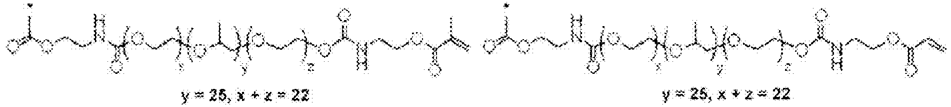

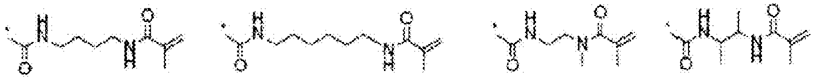

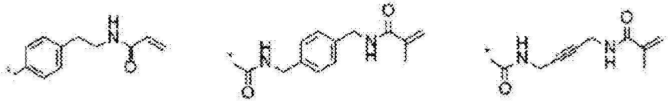

From the viewpoints of the printing durability and the standing fouling resistance, the content of the constitutional repeating unit C in the compound containing a support absorptive group and a hydrophilic group used in the present disclosure is preferably in a range of 1% to 30% by mass, more preferably in a range of 3% to 20% by mass, and still more preferably in a range of 5% to 15% by mass with respect to the total mass of the compound.

Further, it is preferable that the compound containing a support absorptive group and a hydrophilic group is an acrylic resin obtained by polymerizing a (meth)acrylate compound and/or a (meth)acrylamide compound.

In the present disclosure, from the viewpoints of the standing fouling resistance and the developability, the total content of the constitutional repeating unit A and the constitutional repeating unit B in the compound containing a support absorptive group and a hydrophilic group is preferably in a range of 50% to 100% by mass, more preferably in a range of 60% to 100% by mass, and still more preferably in a range of 70% to 100% by mass with respect to the total mass of the compound.

The weight-average molecular weight (Mw) of the compound containing a support absorptive group and a hydrophilic group used in the present disclosure can be optionally set according to the performance design for a planographic printing plate precursor. From the viewpoints of the printing durability and the fouling resistance, the weight-average molecular weight thereof is preferably in a range of 2000 to 1000000, more preferably in a range of 4000 to 500000, and particularly preferably in a range of 5000 to 400000. In a case where the weight-average molecular weight thereof is in the above-described range, the printing durability and the standing fouling resistance are excellent.

The weight-average molecular weight (Mw) of the compound containing a support absorptive group and a hydrophilic group can be measured according to a gel permeation chromatography (GPC) method using polyethylene glycol as a standard substance.

The compound containing a support absorptive group and a hydrophilic group used in the present disclosure can be synthesized according to a known method. For this synthesis, a radical polymerization method and a urea formation reaction using an amino group in a polymer side chain and isocyanates containing a radical polymerization reactive group or an amidation reaction using an amino group in a polymer side chain and an acid anhydride containing a radical polymerization reactive group, continued by the radical polymerization method, are preferably used.

Typical radical polymerization methods are described in, for example, New Polymer Experimental Study 3 (edited by The Society of Polymer Science, Japan, published by Kyoritsu Shuppan Co., Ltd., March 28, 1996), Synthesis and Reaction of Polymer 1 (edited by The Society of Polymer Science, Japan, published by Kyoritsu Shuppan Co., Ltd., May, 1992), New Experimental Chemistry Course 19, Polymer Chemistry (I) (edited by The Chemical Society of Japan, Maruzen, November 20, 1980), and Material Engineering Course Polymer Synthesis Chemistry (published by Tokyo Denki University Press, September 1995), and these can be applied.

The compound containing a support absorptive group and a hydrophilic group in the interlayer used in the present disclosure may be used alone or in combination of two or more kinds thereof.

The content of the compound containing a support absorptive group and a hydrophilic group in the interlayer used in the present disclosure is preferably in a range of 50% to 100% by mass, more preferably in a range of 60% to 100% by mass, and still more preferably in a range of 70% to 100% by mass with respect to the total mass of the total solid content obtained by excluding volatile components from the interlayer.

A method of forming the interlayer is not particularly limited, and the interlayer can be formed using a known method. As an example of the method, the interlayer can be suitably formed by coating an aluminum support with water or a mixed solvent of water and a water-soluble organic solvent (an alcohol compound or the like) and then drying the support.

The coating amount (the mass of the total solid content) of the interlayer used in the present disclosure is preferably in a range of 0.1 to 100 mg/m² and more preferably in a range of 1 to 30 mg/m².

Specific preferred examples of the compound containing a support absorptive group and a hydrophilic group used in the present disclosure include the following undercoat compounds 1 to 7.

Further, other specific preferred examples of the compound containing a support absorptive group and a hydrophilic group used in the present disclosure will be shown together with the weight-average molecular weights thereof, but the present disclosure is not limited thereto. Further, the compositional ratio (the content ratio of a constitutional unit) of a polymer structure represents the mass percentage, and n and m represent a repetition number of alkyleneoxy structures.

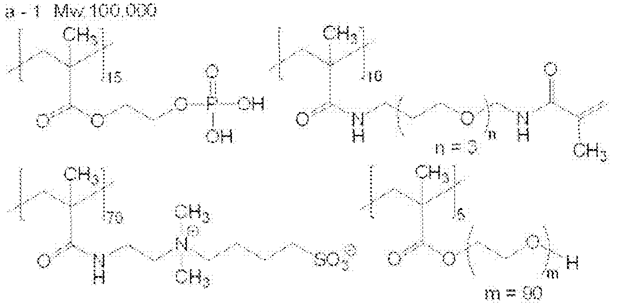

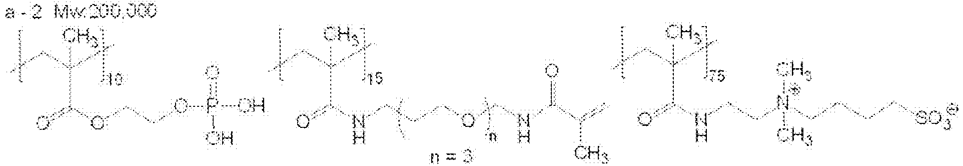

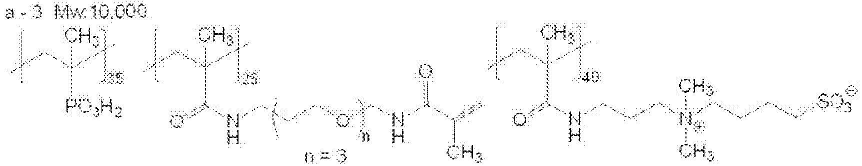

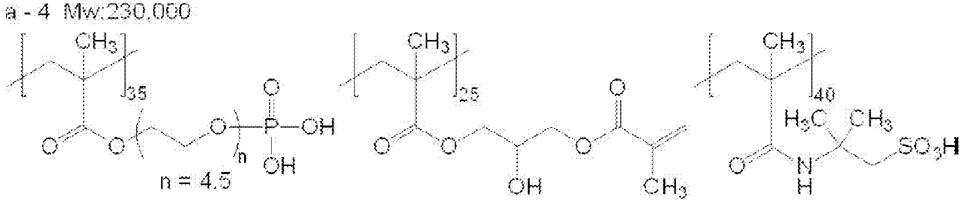

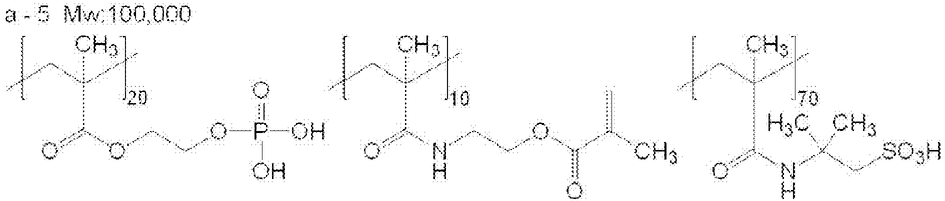

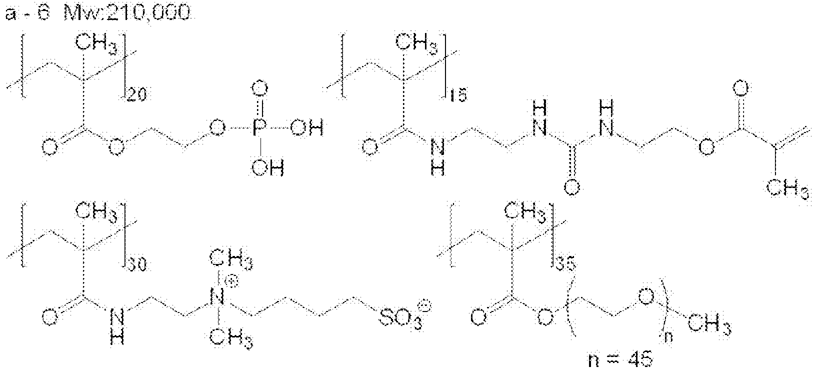

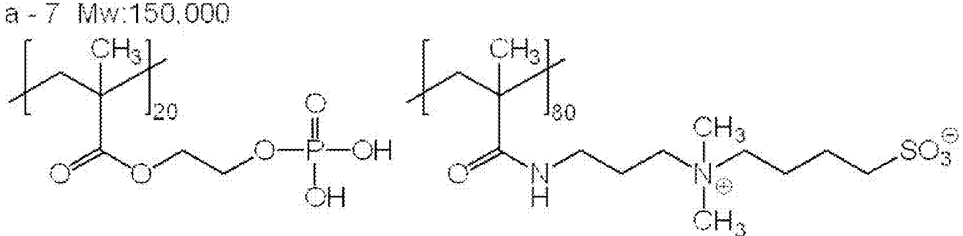

In the present disclosure, it is preferable that the interlayer or the image recording layer contains a water-soluble polymer compound which is different from the compound containing a support absorptive group and a hydrophilic group and does not have a phosphonic acid structure, a phosphonate structure, a phosphoric acid ester structure, and a phosphoric acid ester salt structure and more preferable that the image recording layer contains a water-soluble polymer compound which does not have a phosphonic acid structure, a phosphonate structure, a phosphoric acid ester structure, and a phosphoric acid ester salt structure. It is preferable that the image recording layer contains the water-soluble polymer compound because the water-soluble polymer compound has a function of efficiently increasing the amount of dampening water to permeate into the interface of the support.

The water-soluble polymer compound is a polymer compound in which 1 g or greater thereof is dissolved in 100 g of water at 25°C, and it is preferable that the water-soluble polymer compound is a polymer compound in which 5 g or greater thereof is dissolved in 100 g of water at 25°C and more preferable that the water-soluble polymer compound is a polymer compound in which 10 g or greater thereof is dissolved in 100 g of water at 25°C.

It is preferable that the water-soluble polymer has at least one repeating unit selected from the group consisting of a structure containing a hydroxy group, a structure containing a carboxy group, a structure containing a pyrrolidone group, and a structure containing an oxyalkylene group, which have an affinity particularly for water and more preferable that the water-soluble polymer has a structure containing an oxyalkylene group as a constitutional repeating unit.

Specific examples of the water-soluble polymer containing a hydroxy group include gum arabic, soya gum, carboxymethyl cellulose, hydroxymethyl cellulose, hydroxyethyl cellulose, polyhydroxyethylated cellulose, hydroxypropyl cellulose, hydroxypropylmethyl cellulose, glyoxalated hydroxypropylmethyl cellulose, hydroxypropylmethyl cellulose phthalate, methyl cellulose, α-cyclodextrin, β-cyclodextrin, γ-cyclodextrin, white dextrin, red dextrin, pullulan, enzymatically degraded etherified dextrin, maltosylated cyclodextrin, alpha-starch, grafted starch, dialdehyde starch, periodic acid modified starch, hydroxyether modified starch, cation starch ether, alkali cellulose, industrial cation starch, and polyvinyl alcohol.

Specific examples of the water-soluble polymer containing a carboxy group include polyacrylic acid, carboxyethyl cellulose, alginic acid, sodium alginate, ammonium alginate, propylene glycol alginate ester, xanthan gum, a copolymer having an acrylic acid unit, polymethacrylic acid, and a copolymer having a methacrylic acid unit.

Specific examples of the water-soluble polymer containing a pyrrolidone group include polyvinylpyrrolidone and a copolymer of vinylpyrrolidone and vinyl acetate.

Specific suitable examples of the water-soluble polymer containing an oxyalkylene group include polyalkylene glycol such as polyethylene glycol, polypropylene glycol, or polyoxyethylene polyoxypropylene glycol (also referred to as a polyoxyethylene-polyoxypropylene condensate), polyglycerin or an ether thereof such as poly(ethylene glycol)methyl ether, poly(ethylene glycol)phenyl ether, polyoxyalkylene monoalkyl or aryl ether, polyoxyethylene polyoxypropylene alkyl ether, polyglycerin, polyoxyethylene glycerin, polyoxypropylene glyceryl ether, or polyoxyethylene polyoxypropylene glyceryl ether, and an ester having a polyoxyalkylene structure such as polyoxyethylene monoester, polyoxyethylene alkyl ether ester, polyoxyethylene glyceryl isostearate, polyoxyethylene glyceryl triisostearate, polyoxyethylene glyceryl triisostearate, polyoxyethylene trimethylolpropane distearate, polyoxyethylene sorbitan monofatty acid ester, polyoxyethylene sorbitan fatty acid ester, polyoxyethylene hardened castor oil, monofatty acid polyoxyethylene hardened castor oil, polyoxyethylene hardened castor oil succinic acid, polyoxyethylene castor oil, polyoxyethylene sorbitol tetraoleate, polyoxyethylene sorbitol tetraisostearate, or polyoxyethylene sorbitol isostearate.

Among these, polyoxyalkylene monoalkyl ether is preferable, and poly(ethylene glycol)methyl ether is more preferable.

Specific preferred examples of the water-soluble polymer compound used in the present disclosure will be shown together with the weight-average molecular weights thereof, but the present disclosure is not limited thereto. Further, the compositional ratio (the content ratio of a constitutional unit) of a polymer structure represents the mass percentage.

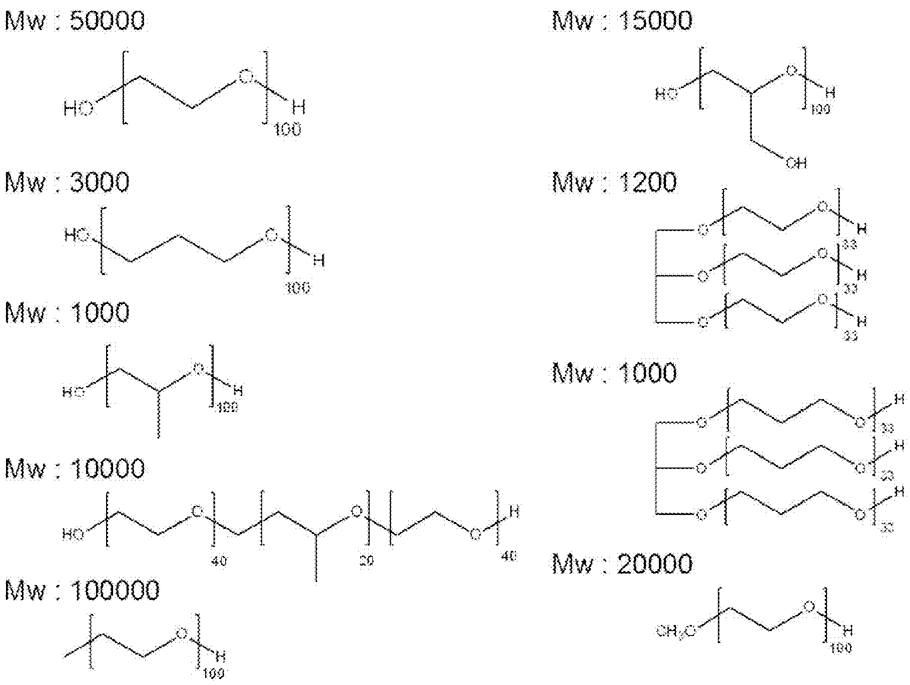

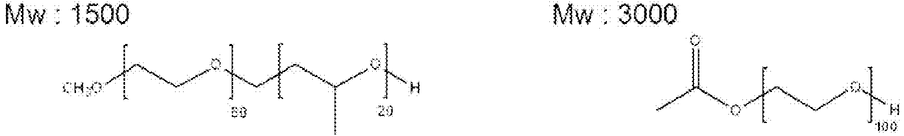

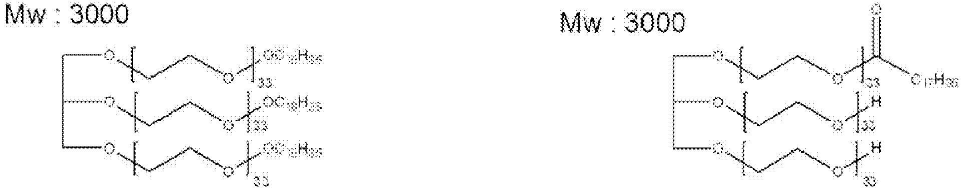

The weight-average molecular weight (Mw) of the water-soluble polymer compound used in the present disclosure can be optionally set according to the performance design for a planographic printing plate precursor. The weight-average molecular weight (Mw) thereof is preferably in a range of 1000 to 200000, more preferably in a range of 3000 to 100000, and still more preferably in a range of 3000 to 50000. In a case where the weight-average molecular weight thereof is in the above-described range, the printing durability and the developability with time are excellent. The weight-average molecular weight (Mw) of the water-soluble polymer compound can be measured according to a gel permeation chromatography (GPC) method using polyethylene glycol as a standard substance.

In the planographic printing plate precursor of the present disclosure, compound containing support absorptive group and hydrophilic group:water-soluble polymer compound is preferably in a range of 1:0.5 to 1:5, more preferably in a range of 1:0.7 to 1:4, and still more preferably in a range of 1:0.8 to 1:3. In a case where the mass ratio thereof is in the above-described range, the printing durability and the developability become excellent.

### <Image recording layer>

The image recording layer in the planographic printing plate precursor of the present disclosure contains an infrared absorbing agent, a polymerization initiator, a polymerizable compound, and polymer particles formed of a styrene copolymer.

The content of the infrared absorbing agent is preferably in a range of 0.01% to 20% by mass, more preferably in a range of 0.1% to 10% by mass, and particularly preferably in a range of 0.5% to 7% by mass with respect to the total mass of the image recording layer.

The content of the polymerization initiator is preferably in a range of 0.01% to 20% by mass, more preferably in a range of 0.1% to 10% by mass, and particularly preferably in a range of 0.5% to 7% by mass with respect to the total mass of the image recording layer.

The content of the polymerizable compound is preferably in a range of 10% to 70% by mass, more preferably in a range of 20% to 60% by mass, and particularly preferably in a range of 30% to 50% by mass with respect to the total mass of the image recording layer.

The content of the polymer particles formed of a styrene copolymer is preferably in a range of 5% to 90% by mass, more preferably in a range of 10% to 80% by mass, still more preferably in a range of 15% to 50% by mass, and particularly preferably in a range of 20% to 40% by mass with respect to the total mass of the image recording layer.

The image recording layer in the planographic printing plate precursor of the present disclosure may contain a binder polymer other than the polymer particles formed of a styrene copolymer.

The content of the binder polymer is preferably in a range of 5% to 80% by mass and more preferably in a range of 10% to 50% by mass with respect to the total mass of the image recording layer.

Each component in the image recording layer may be used alone or in combination of two or more kinds thereof.

### [Infrared absorbing agent]

The image recording layer contains an infrared absorbing agent.

It is preferable that the infrared absorbing agent is a compound having maximum absorption in a wavelength range of 750 to 1400 nm.

As the infrared absorbing agent which can be used in the present disclosure, an infrared absorbing agent which is known as a "photothermal conversion material" is exemplified.

As the photothermal conversion material, a material that absorbs infrared rays and converts the absorbed infrared rays into heat is preferable. The photothermal conversion material is not necessary for forming an image using a high temperature body, but an image-formable element containing this photothermal conversion material can be used for forming an image using a high temperature body, for example, a thermal head or a thermal head array.

The photothermal conversion material may be an optional material which is capable of absorbing infrared rays and converting the absorbed infrared rays into heat. Suitable examples of the material include dyes and pigments. Suitable examples of the pigments include carbon black, Heliogen Green, Nigrosin Base, iron oxide (III), manganese oxide, Prussian Blue, and Paris Blue. The size of the pigment particles does not exceed the thickness of the layer containing a pigment. Most suitably, the size of the particles is less than half the thickness of the layer.

It is preferable that the amount of the infrared absorbing agent in the image recording layer is set such that the optical density of the image recording layer is 0.05 or greater and more preferable that the amount thereof is set such that the optical density of the image recording layer is in a range of 0.5 to 3 at an image forming wavelength.

The photothermal conversion material may contain a dye having a suitable absorption spectrum and a solubility.

As the dye, a dye having maximum absorption particularly in a wavelength range of 750 to 1200 nm is preferable. Suitable examples of the dye include the following class of dyes: methine, polymethine, arylmethine, cyanine, hemicyanine, strepto cyanine, squarylium, pyrylium, oxonol, naphthoquinone, anthraquinone, porphyrin, azo, croconium, triarylamine, thiazolium, indolium, oxazolium, indocyanine, indotricarbocyanine, oxatricarbocyanine, phthalocyanine, thiocyanine, thiatricarbocyanine, merocyanine, cryptocyanine, naphthalocyanine, polyaniline, polypyrrole, polythiophene, chalcogenopyryloallylidene, bis(chalcogenopyrylo)polymethine, oxyindolizine, pyrazolineazo, and oxazine.

The infrared absorbing agents are disclosed in a plurality of publications, for example, EP0823327A (Nagasaka et al.), US4973572A (DeBoer), and US5208135A (Patel et al.). Other useful examples of the infrared absorbing agent include ADS-830A and ADS-1064 which are available from American Dye Source, Inc. (Baie D'Urfe, Quebec, Canada).

Further, as the infrared absorbing agent, a water-soluble photothermal conversion material is preferable.

It is preferable that the water-soluble photothermal conversion material contains a cyanine dye containing one or two or more sulfate groups or sulfonate groups. An infrared absorbing cyanine anion containing two to four sulfonate groups is reported in JP5107063A (West et al.), US5972838A (Pearce et al.), US6187502A (Chapman et al.), and US5330884A (Fabricius et al.).

Among these, preferred examples of the infrared absorbing agent include a cyanine dye such as a cyanine compound, a hemicyanine compound, a strepto cyanine compound, an indocyanine compound, an indotricarbocyanine compound, an oxatricarbocyanine compound, a phthalocyanine compound, a thiocyanine compound, a thiatricarbocyanine compound, a merocyanine compound, a cryptocyanine compound, or a naphthalocyanine compound, a squarylium dye, a pyrylium salt, and a nickel thiolate complex. Among these, a cyanine dye is more preferable.

### [Polymerization initiator]

The image recording layer contains a polymerization initiator.

The polymerization initiator may be a photopolymerization initiator or a thermal polymerization initiator, but it is preferable that the image recording layer contains a photopolymerization initiator.

Further, as the polymerization initiator, a radical polymerization initiator is preferable, and a photoradical polymerization initiator is more preferable.

It is preferable that the polymerization initiator is a compound that generates polymerization initiation species using light having a wavelength of 300 to 1400 nm (such as ultraviolet rays, visible light rays, and infrared rays).

In the present disclosure, the polymerization initiator is not particularly limited, but photoradical polymerization initiators described in JP2013-205569A are preferably used. Among these, an onium salt is preferable.

Examples of the onium salt include an iodonium salt and a sulfonium salt. Hereinafter, specific examples of these compounds will be described, but the present disclosure is not limited to these.

As the iodonium salts, diphenyliodonium salts are preferable, electron-donating groups such as diphenyl iodonium salts substituted with an alkyl group or an alkoxyl group are particularly preferable, and asymmetric diphenyl iodonium salts are still more preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium=1-perfluorobutanesulfonate, 4-octyloxyphenyl-2,4,6-trimethoxyphenyliodonium=hexafluorophosphate, and bis(4-t-butylphenyl)iodonium=tetraphenylborate.

As the sulfonium salt, a triaryl sulfonium salt is preferable.

Examples of the sulfonium salts include triphenylsulfonium=hexafluorophosphate, triphenylsulfonium=benzoylformate, bis(4-chlorophenyl)phenylsulfonium=benzoylformate, bis(4-chlorophenyl)-4-methylphenylsulfonium=tetrafluoroborate, tris(4-chlorophenyl)sulfonium=3,5-bis(methoxycarbonyl)benzenesulfonate, and tris(4-chlorophenyl)sulfonium=hexafluorophosphate.

Among these, an iodonium salt is preferable. It is particularly preferable that the onium salt is used in combination with an infrared absorbing agent having maximum absorption in a wavelength range of 750 to 1400 nm.

Further, the onium salt functions not only as a photopolymerization initiator but also as a thermal polymerization initiator (particularly acting concertedly with an infrared absorbing agent).

Further, the infrared absorbing agent may act as a sensitizer of a photopolymerization initiator.

Examples of the thermal polymerization initiator include a peroxide such as benzoyl peroxide; hydroperoxide such as cumyl hydroperoxide; an azo compound such as azobis-isobutylonitrile; a 2,4,5-triarylimidazolyl dimer (hexaarylbisimidazole) as disclosed in US4565769A (Dueber et al.); trihalomethyl triazine; a borate; and a mixture of these.

Further, image recording layer may further contain a sensitizer.

Examples of the combination of a sensitizer and a polymerization initiator include trihalomethyl triazine in a state of being used alone or in combination with a photosensitizer as described in US4997745A (Kawamura et al.); a spectral sensitizer for activating visible light in a state of being used alone or in combination with trihalomethyl triazine as described in US5599650A (Bi et al.); 3-ketocoumarin for activating ultraviolet rays and visible light in a state of being used in combination with a photooxidant containing a heterocyclic nitrogen atom substituted with a polycarboxylic acid coinitiator such as aniline-N,N-diacetic acid and a secondary coinitiator such as a diaryliodonium salt, titanocene, haloalkyl triazine, hexaaryl bisimidizole, a borate, an alkoxy group, or an acyloxy group as described in US5942372A (West et al); a coinitiator containing a carboxylic acid group bonded, through a methylene group, to a N, O, or S group which is directly bonded to a cyanine dye, a diaryliodonium salt, and an aromatic ring as described in US5368990A (Kawabata et al.); a cyanine dye for activating infrared rays in a state of being used in combination with trihalomethyl triazine and an organic borate as described in US5496903A (Watanabe et al.); a compound which contains an infrared absorbing agent, trichloromethyl triazine, and an azinium compound and generates starting free radicals, and a polycarboxylic acid coinitiator containing a carboxylic acid group bonded, through a methylene group, to a N, O, or S group which is directly bonded to an aromatic ring as described in US6309792A (Hauck et al.).

### [Polymerizable compound]

The image recording layer contains a polymerizable compound.

As the polymerizable compound, an ethylenically unsaturated compound is preferably exemplified.

The ethylenically unsaturated compound may be monofunctional or polyfunctional, but a polyfunctional ethylenically unsaturated compound is preferable.

The polymerizable compound has a chemical form such as a monomer, a pre-polymer, that is, a dimer, a trimer, an oligomer, a polymer, or a mixture of these.

As the polyfunctional ethylenically unsaturated compound, an unsaturated ester of alcohol is preferable, and acrylate ester and methacrylate ester of a polyol are more preferable.

As an oligomer or a prepolymer, for example, urethane acrylate, urethane methacrylate, epoxide acrylate, epoxide methacrylate, polyester acrylate, polyester methacrylate, polyether acrylate, polyether methacrylate, and an unsaturated polyester resin can be used.

Among these, at least one compound selected from the group consisting of an acrylate compound and a methacrylate compound is preferable, and at least one compound selected from the group consisting of a polyfunctional acrylate compound and a polyfunctional methacrylate compound is more preferable.

Further, from the viewpoint of the printing durability, it is preferable that the polymerizable compound has a urethane bond.

Preferred examples of the polymerizable compound having a urethane bond include a urethane (meth)acrylate compound.

Examples of the polymerizable compound include those described in "Photoreactive Polymers: The Science and Technology of Resists" written by A. Reiser, Wiley, New York, 1989, p. 102 to 177; "Photopolymers: Radiation Curable Imaging Systems" written by B. M. Monroe; "Radiation Curing: Science and Technology" edited by S. P. Pappas, Plenum, New York, 1992, p. 399 to 440; "Polymer imaging" written by A. B. Cohen and P. Walker; and "Imaging Processes and Material" edited by J. M. Sturge et al., Van Nostrand Reinhold, New York, 1989, p. 226 to 262.

### [Polymer particles formed of styrene copolymer]

The image recording layer contains polymer particles formed of a styrene copolymer as specified in claim 1. Accordingly, the styrene copolymer is a copolymer of a styrene-(meth)acrylonitrile-poly(ethylene glycol)monoalkylether (meth)acrylate compound.

The styrene copolymer may be a copolymer having at least a monomer unit (the following monomer unit) derived from styrene and is preferably a copolymer having 1% to 95% by mass of the following monomer unit with respect to the total content of the copolymer, more preferably a copolymer having 2% to 90% by mass of the following monomer unit with respect to the total content of the copolymer, still more preferably a copolymer having 5% to 60% by mass of the following monomer unit with respect to the total content of the copolymer, and particularly preferably a copolymer having 5% to 40% by mass of the following monomer unit with respect to the total content of the copolymer.

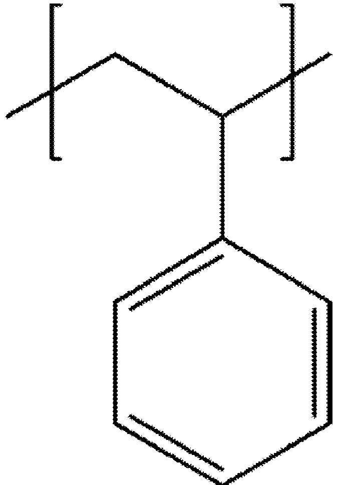

Examples of the (meth)acrylonitrile compound include (meth)acrylonitrile. Among these, acrylonitrile is preferable.

As examples of the (meth)acrylate compound, poly(alkylene glycol)monoalkyl ether (meth)acrylate and alkyl(meth)acrylate are preferable; poly(alkylene glycol)monoalkyl ether (meth)acrylate is more preferable; and poly(ethylene glycol)monoalkyl ether (meth)acrylate is particularly preferable.

Examples of the conjugated diene compound include butadiene and isoprene.

Examples of the styrene compound other than styrene include α-methyl styrene, 4-methylstyrene, 4-hydroxystyrene, 4-acetoxystyrene, 4-acetylstyrene, and styrene sulfonic acid.

Further, it is preferable that the styrene copolymer is a copolymer obtained by copolymerizing a macromonomer.

A macromonomer is a monomer having a polymer chain and a polymerizable group. For example, a graft polymer can be easily formed by copolymerizing a monofunctional macromonomer.

The weight-average molecular weight of the macromonomer is preferably in a range of 300 to 10000.

Specific preferred examples of the macromonomer include polyethylene glycol monomethacrylate, polypropylene glycol methyl ether methacrylate, polyethylene glycol ethyl ether methacrylate, polyethylene glycol butyl ether methacrylate, polypropylene glycol hexyl ether methacrylate, polypropylene glycol octyl ether methacrylate, polyethylene glycol methyl ether acrylate, polyethylene glycol ethyl ether acrylate, polyethylene glycol phenyl ether acrylate, polypropylene glycol monoacrylate, polypropylene glycol monomethacrylate, polypropylene glycol methyl ether methacrylate, polypropylene glycol ethyl ether methacrylate, polypropylene glycol butyl ether methacrylate, polyethylene glycol/polypropylene glycol methyl ether methacrylate, poly(vinyl alcohol)monomethacrylate, poly(vinyl alcohol)monoacrylate, and a mixture of these. Among these, a poly(alkylene glycol)alkyl ether (meth)acrylate compound is preferable, and a poly(ethylene glycol)alkyl ether (meth)acrylate compound is more preferable. With the above-described aspects, the on-press developability and the on-press developability with time become excellent.

The number of carbon atoms of the alkyl group in the alkyl ether structure of the poly(alkylene glycol)alkyl ether (meth)acrylate compound is preferably in a range of 1 to 10, more preferably in a range of 1 to 8, and still more preferably in a range of 1 to 4.

Further, the weight-average molecular weight of the poly(alkylene glycol)alkyl ether (meth)acrylate compound is preferably in a range of 300 to 10,000, more preferably in a range of 500 to 8,000, and still more preferably in a range of 1,000 to 5,000.

In the present disclosure, the weight-average molecular weight of polymer components indicates the weight-average molecular weight (Mw) in terms of polystyrene to be measured using gel permeation chromatography (GPC) in a case where tetrahydrofuran (THF) is used as a solvent, unless otherwise noted.

The styrene copolymer has a polyethyleneoxy chain. As specified in claim 1 the styrene copolymer is a copolymer of a styrene-(meth)acrylonitrile-poly(alkylene glycol)alkyl ether (meth)acrylate compound. With the above-described aspects, the on-press developability and the on-press developability with time become excellent.

Examples of the monomer forming the styrene copolymer include an alkyl (meth)acrylate compound.

From the viewpoint of the hardness of the polymer particles, it is preferable that the alkyl (meth)acrylate compound is an alkyl methacrylate compound.

Further, the number of carbon atoms of the alkyl group in the alkyl (meth)acrylate compound is preferably in a range of 1 to 10, more preferably in a range of 1 to 4, still more preferably 1 or 2, and particularly preferably 1.

As the alkyl (meth)acrylate compound, methyl methacrylate or ethyl methacrylate is preferable and methyl methacrylate is more preferable.

Further, as the monomer forming the styrene copolymer, glycidyl (meth)acrylate is also preferably exemplified.

Further, examples of monomers other than the monomer which can be used for the preparing the styrene copolymer include acrylic acid, methacrylic acid, allyl methacrylate, hydroxyethyl methacrylate, 2-ethoxyethyl methacrylate, 3-methoxypropyl methacrylate, methacrylamide, vinyl acetate, vinyl butyrate, methyl vinyl ketone, butyl vinyl ketone, vinyl fluoride, vinyl chloride, vinyl bromide, maleic anhydride, maleimide, N-phenyl maleimide, N-cyclohexyl maleimide, and N-benzyl maleimide.

The content of the monomer unit derived from styrene in the styrene copolymer is preferably in a range of 1% to 50% by mass, more preferably in a range of 2% to 40% by mass, and still more preferably in a range of 5% to 35% by mass with respect to the total mass of the copolymer.

In a case where the styrene copolymer is a copolymer obtained by copolymerizing (meth)acrylonitrile, the content of the monomer unit derived from (meth)acrylonitrile in the styrene copolymer is preferably in a range of 5% to 98% by mass, more preferably in a range of 10% to 95% by mass, still more preferably in a range of 20% to 95% by mass, and particularly preferably in a range of 55% to 90% by mass with respect to the total mass of the copolymer.

In a case where the styrene copolymer is a copolymer obtained by copolymerizing a poly(alkylene glycol)alkyl ether methacrylate compound, the content of the monomer unit derived from the poly(alkylene glycol)alkyl ether methacrylate compound in the styrene copolymer is preferably in a range of 1% to 40% by mass, more preferably in a range of 3% to 30% by mass, and still more preferably in a range of 5% to 15% by mass with respect to the total mass of the copolymer.

The weight-average molecular weight of the styrene copolymer is preferably in a range of 3000 to 100000, more preferably in a range of 5000 to 80000, and still more preferably in a range of 10000 to 60000.

The number average particle diameter of the polymer particles is preferably in a range of 10 to 1000 nm, more preferably in a range of 100 to 700 nm, still more preferably in a range of 100 to 300 nm, and particularly preferably in a range of 150 to 250 nm.

A method of producing the polymer particles is not particularly limited, and a known method of producing a polymer or a known method of producing known polymer particles can be used.

### [Binder polymer]

The image forming layer may contain one or two or more binder polymers other than the polymer particles.

The binder polymer may or may not be particulate, but it is preferable that the binder polymer is not particulate.

Examples of the binder polymer include a water-soluble or water-dispersible polymer, for example, a cellulose derivative such as carboxymethyl cellulose, methyl cellulose, hydroxypropylmethyl cellulose, hydroxypropyl cellulose, or hydroxyethyl cellulose; polyvinyl alcohol; polyacrylic acid; polymethacrylic acid; polyvinylpyrrolidone; polylactide and polyvinylphosphonic acid; a synthetic copolymer, for example, a copolymer of alkoxypolyethylene glycol acrylate or alkoxypolyethylene glycol methacrylate such as methoxypolyethylene glycol acrylate or methoxypolyethylene glycol methacrylate and a monomer such as methyl methacrylate, methyl acrylate, butyl methacrylate, butyl acrylate, or allyl methacrylate; and a mixture of these.

Further, the above-described water-soluble polymer compound is suitably exemplified as the binder polymer.

The content of the binder polymer other than the polymer particles in the image forming layer is preferably in a range of 0% to 50% by mass and more preferably in a range of 1% to 30% by mass with respect to the total mass of the image forming layer.

### [Other additives]

The image recording layer may further contain other additives in addition to those described above.

Known additives can be used as other additives, and the additives described in JP2013-205569A can be appropriately used.

Further, examples of other additives include surfactants and contrast dyes.

The total content of other additives is preferably in a range of 0% to 20% by mass and more preferably in a range of 0% to 5% by mass with respect to the total mass of the image recording layer.

Moreover, examples of the other additives include additives used for improving the preservation life of the image recording layer.

Examples of the additives which are capable of effectively improving the preservation life include a mercapto compound, an amino compound, an amino compound, monocarboxylic acid, and polycarboxylic acid.

A suitable mercapto compound is described in US2002/0197564A (Timpe et al.) and the like. Suitable polycarboxylic acid described in US6309792A (Hauck et al.) includes an aromatic moiety substituted with a heteroatom. Suitable monocarboxylic acid additives are described in US2004/0091811A (Munnelly et al.) and US2004/0259027A (Munnelly et al.).

### [Formation of image recording layer]

The method of forming the image recording layer in the present disclosure is not particularly limited, and the image recording layer can be formed on the interlayer according to a known method such as a coating method or a lamination method.

Specifically, for example, each component of the image recording layer is dispersed or dissolved in a suitable coating solvent, for example, water or a mixed solvent of water and an organic solvent such as a mixture of water and at least one organic solvent selected from the group consisting of methanol, ethanol, isopropyl alcohol, and acetone. A surfactant, for example, a fluorinated surfactant, a polyethoxylated dimethyl polysiloxane copolymer or a mixture of surfactants may be present to assist dispersion of other components in the coating solvent. The interlayer is coated with the mixture obtained as the result of dissolution according to a known method such as spin coating, bar coating, gravure coating, die coating, slot coating, or roller coating.

After the interlayer is coated with the mixture, the solvent is evaporated by drying the image recording layer. The image recording layer can be air-dried in a furnace or the like at an ambient temperature or a high temperature. Alternatively, the image recording layer can be dried by blowing hot air thereto.

The mass of the image recording layer to be dried and coated is preferably in a range of 0.2 to 5.0 g/cm², more preferably in a range of 0.5 to 1.5 g/cm², and particularly preferably in a range of 0.75 to 1.0 g/cm².

It is preferable that the image recording layer used in the planographic printing plate precursor of the present disclosure can be removed by at least one selected from the group consisting of a dampening water composition and a printing ink.

### <Protective layer>

In the planographic printing plate precursor of the present disclosure, a protective layer (oxygen blocking layer) may be provided on the image recording layer in order to block diffusion penetration of oxygen that disturbs a polymerization reaction during exposure.

As the material of the protective layer, any of a water-soluble polymer and a water-insoluble polymer can be appropriately selected and used, and two or more kinds thereof can be used in combination as necessary. Specific examples thereof include polyvinyl alcohol, modified polyvinyl alcohol, polyvinylpyrrolidone, a water-soluble cellulose derivative, and poly(meth)acrylonitrile. Among these, a water-soluble polymer compound having relatively excellent crystallinity is preferably used. Specifically, in a case where polyvinyl alcohol is used as a main component, this leads to excellent results particularly for basic characteristics such as oxygen blocking properties and development removability.

As the polyvinyl alcohol used for the protective layer, those described in paragraphs 0216 and 0217 in JP2013-205569A can be used as appropriate.

For the purpose of improving oxygen blocking properties or surface protection properties of the image recording layer, it is also preferable that the protective layer contains an inorganic layered compound. Among examples of the inorganic layered compound, a fluorine-based swellable synthetic mica which is a synthetic inorganic layered compound is particularly useful. Specifically, inorganic layered compounds described in JP2005-119273A are suitably exemplified.

The coating amount of the protective layer is preferably in a range of 0.05 to 10 g/m², more preferably in a range of 0.1 to 5 g/m² in a case where the protective layer contains an inorganic layered compound, and still more preferably in a range of 0.5 to 5 g/m² in a case where the protective layer does not contain an inorganic layered compound.

### <Back coat layer>

The planographic printing plate precursor of the present disclosure may be provided with a back coat layer on the rear surface of the aluminum support as necessary. As the back coat layer, a coating layer formed of a metal oxide obtained by hydrolyzing and polycondensing an organic polymer compound described in JP1993-45885A (JP-H05-45885A) and an organic metal compound or an inorganic metal compound described in JP1994-35174A (JP-H06-35174A) is suitably exemplified. Among these, from the viewpoints of inexpensive raw materials and easily obtaining the raw materials, it is preferable to use an alkoxy compound of silicon such as Si(OCH₃)₄, Si(OC₂H₅)₄, Si(OC₃H₇)₄, or Si(OC₄H₉)₄.

### (Method of preparing planographic printing plate and planographic printing method)

A planographic printing plate can be prepared by image-exposing the planographic printing plate precursor for on-press development of the present disclosure and performing a development treatment thereon.

The method of preparing a planographic printing plate of the present disclosure includes an exposure step of imagewise-exposing the planographic printing plate precursor for on-press development of the present disclosure to form an exposed portion and an unexposed portion; and an on-press development step of supplying at least one of a printing ink or dampening water and removing the unexposed portion.

The planographic printing method of the present disclosure includes an exposure step of imagewise-exposing the planographic printing plate precursor for on-press development of the present disclosure to form an exposed portion and an unexposed portion; an on-press development step of supplying at least one of a printing ink or dampening water and removing the unexposed portion; and a printing step of supplying the printing ink to a planographic printing plate on-press-developed in the on-press development step to print a recording medium.

Hereinafter, preferable aspects of each step in the method of preparing a planographic printing plate of the present disclosure and the planographic printing method of the present disclosure will be sequentially described. Further, the planographic printing plate precursor for on-press development of the present disclosure can be developed by a developer.

In addition, the preferable aspects of the exposure step and the on-press development step in the method of preparing a planographic printing plate of the present disclosure are the same as the preferable aspects of the exposure step and the on-press development step in the planographic printing method of the present disclosure.

### <Exposure step>

It is preferable that the method of preparing a planographic printing plate of the present disclosure includes an exposure step of imagewise-exposing the planographic printing plate precursor for on-press development of the present disclosure to form an exposed portion and an unexposed portion. It is preferable that the planographic printing plate precursor for on-press development of the present disclosure is image-exposed by laser exposure through a transparent original picture having a line image, a halftone image, and the like or by laser beam scanning using digital data.

The wavelength of a light source is preferably in a range of 750 to 1,400 nm. As the light source having a wavelength of 750 to 1,400 nm, a solid-state laser or a semiconductor laser that radiates infrared rays is suitable. The output of the infrared laser is preferably 100 mW or greater, the exposure time per one pixel is preferably less than 20 microseconds, and the irradiation energy quantity is preferably in a range of 10 to 300 mJ/cm². For the purpose of reducing the exposure time, it is preferable to use a multi-beam laser device. The exposure mechanism may be any of an internal drum system, an external drum system, and a flat bed system.

The image exposure can be performed using a plate setter according to a conventional method. In a case of the on-press development, the planographic printing plate precursor is mounted on the printing press, and image exposure may be performed on the printing press.

### <On-press development step>

It is preferable that the method of preparing a planographic printing plate of the present disclosure includes the on-press development step of supplying at least one of a printing ink or dampening water and removing the unexposed portion.

Further, the method of preparing a planographic printing plate of the present disclosure may be performed using a method (developer treatment system) of performing development in a developer.

Hereinafter, the on-press development system will be described.

### [On-press development system]

In the on-press development system, it is preferable that the image-exposed planographic printing plate precursor supplies an oily ink or an aqueous component on a printing press, and the image recording layer in the non-image area is removed so that a planographic printing plate is prepared.

In other words, in a case where the planographic printing plate precursor is image-exposed and then mounted on the printing press without performing any development treatment or the planographic printing plate precursor is mounted on the printing press, image-exposed on the printing press, and supplies an oily ink and an aqueous component for printing, an uncured image recording layer is dissolved or dispersed and then removed by the supplied oily ink and the aqueous component in a non-image area at the initial stage of printing, and the hydrophilic surface is exposed to the removed portion. In addition, in the exposed portion, the image recording layer cured due to exposure forms an oily ink receiving portion having a lipophilic surface. The oily ink or the aqueous component may be initially supplied to the plate surface, but it is preferable that the oily ink is initially supplied to the plate surface from the viewpoint of preventing contamination due to the components of the image recording layer from which the aqueous component has been removed. In this manner, the planographic printing plate precursor is subjected to on-press development on the printing press and used as it is for a plurality of sheets of printing. As the oily ink and the aqueous component, a typical printing ink for planographic printing and dampening water are suitably used.

### <Printing step>

The planographic printing method of the present disclosure includes a printing step of supplying the printing ink to a planographic printing plate on-press-developed in the on-press development step to print a recording medium.

The printing ink is not particularly limited, and various known inks can be used as desired. Further, an oily ink is preferably exemplified as the printing ink.

Further, in the printing step, dampening water may be supplied as necessary.

Further, the printing step may be performed continuously after the on-press development step without stopping the printing press.

The recording medium is not particularly limited, and a known recording medium can be used as desired.

In the method of preparing a planographic printing plate obtained from the planographic printing plate precursor for on-press development of the present disclosure and the planographic printing method of the present disclosure, the entire surface of the planographic printing plate precursor may be heated before exposure, during exposure, or between exposure and development as necessary. In a case where the entire surface thereof is heated, the image forming reaction in the image recording layer is promoted so that the sensitivity or the printing durability is improved and the sensitivity is stabilized. It is preferable that the heating before development is performed under a mild temperature condition of 150°C or lower. With the above-described aspect, a problem of a non-image area being cured can be prevented. It is preferable that extremely strong conditions are used for the heating after development, and the temperature is preferably in a range of 100°C to 500°C. In a case where the temperature is in the above-described range, an image-strengthening action is sufficiently obtained, and deterioration of the support and thermal decomposition of the image area can be suppressed.

### Examples

In the following only examples comprising in combination the features defined in appended claim 1 are examples of the present invention. Other examples are reference examples. Comparative examples are also provided.

Hereinafter, the characteristics of the embodiments of the present invention will be described in more detail with reference to the examples. The materials, the used amounts, the proportions, the treatment contents, and the treatment procedures described in the following examples can be appropriately changed without departing from the gist of the embodiments of the present invention. Accordingly, the scope of the embodiments of the present invention should not be limitatively interpreted by the following specific examples.

Further, "part" and "%" respectively represent "part(s) by mass" and "% by mass" unless otherwise specified.

Further, each numerical value on the lower right side of the parentheses representing a constitutional unit in an undercoat compound represents the mass ratio.

### [I] Preparation of planographic printing plate precursors

Twenty four planographic printing plate precursors were prepared in the following manners.

### [Planographic printing plate precursor 1]

### (1) Preparation of support (1)

As roughening treatments, the following (a) to (e) treatments were performed. Further, a washing treatment with water was performed between all treatment steps.

### (a) Alkali etching treatment

An aluminum plate (material JIS 1052) having a thickness of 0.3 mm was subjected to an etching treatment by spraying an aqueous solution at a temperature of 60°C in which the concentration of caustic soda was 25% by mass and the concentration of aluminum ions was 100 g/L using a spray tube. The etching amount of the surface of the aluminum plate to be subjected to an electrochemical roughening treatment was 3 g/m².

### (b) Desmutting treatment

Next, a desmutting treatment was performed by spraying a sulfuric acid aqueous solution (concentration of 300 g/L) at a temperature of 35°C for 5 seconds from the spray tube.

### (c) Electrolytic roughening treatment

Thereafter, an electrochemical roughening treatment was continuously performed using an electrolytic solution (liquid temperature of 35°C) obtained by dissolving aluminum chloride in a 1 mass% hydrochloric acid aqueous solution and adjusting the aluminum ion concentration to 4.5 g/L, a 60 Hz AC power source, and a flat cell type electrolytic cell. A sine wave was used as the waveform of the AC power source. In the electrochemical roughening treatment, the current density of the anodic reaction of the aluminum plate at the peak of the alternating current was 30 A/dm². The ratio between the total electric quantity during the anodic reaction and the total electric quantity during the cathodic reaction of the aluminum plate was 0.95. The electric quantity was set to 480 C/dm² in terms of the total electric quantity during the anodic reaction of the aluminum plate. The electrolytic solution was circulated using a pump so that the stirring inside the electrolytic cell was performed.

### (d) Alkali etching treatment

The aluminum plate was subjected to an etching treatment by spraying an aqueous solution at a temperature of 35°C in which the concentration of caustic soda was 5% by mass and the concentration of aluminum ions was 5 g/L using a spray tube. The etching amount of the surface of the aluminum plate on which the electrolytic roughening treatment had been performed was 0.05 g/m².

### (e) Desmutting treatment

Next, a desmutting treatment was performed by spraying an aqueous solution at a liquid temperature of 35°C with a sulfuric acid concentration of 300 g/L and an aluminum ion concentration of 5 g/L from the spray tube for 5 seconds.

The aluminum plate on which the roughening treatment had been performed was subjected to an anodizing treatment at a treatment temperature of 38°C and a current density of 15A/dm² using a 22 mass% phosphoric acid aqueous solution as an electrolytic solution.

Thereafter, the aluminum plate was washed with water using a spray. The final amount of the oxide film was 1.5 g/m². The surface of the substrate was imaged at a magnification of 150000 using an electronic microscope and the average pore diameter in a case of n = 90 was actually measured, and the value was 30 nm.

The support (1) was coated with the following undercoat liquid (1) such that the dried coating amount thereof was set to 20 mg/m² and dried in an oven at 100°C for 30 seconds to prepare a support used for the following experiment.

### <Undercoat liquid (1)>

- Undercoat compound 1 shown below: 0.18 parts
- Methanol: 55.24 parts
- Distilled water: 6.15 parts

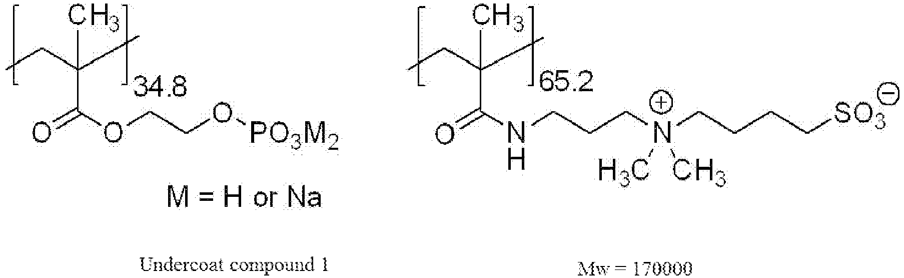

### (2) Formation of image forming layer

The support including an undercoat layer was bar-coated with an image forming layer coating solution (1) with the following composition and dried in an oven at 94°C for 60 seconds to form an image forming layer having a dried coating amount of 0.85 g/m².

### <Image forming layer coating solution (1)>

- Polymerizable compound 1 *1: 0.325 parts
- Graft copolymer 1 *2: 0.060 parts
- Graft copolymer 2 *3: 0.198 parts
- Mercapto-3-triazole *4: 0.180 parts
- Irgacure 250 *5: 0.032 parts
- Infrared absorbing agent 1 (the following structure): 0.007 parts
- Sodium tetraphenylborate (the following structure): 0.04 parts
- Klucel 99M *6: 0.007 parts
- Byk 336 *7: 0.015 parts
- n-Propanol: 7.470 parts
- Water: 1.868 parts
   *1: Dipentaerythritol hexaacrylate (manufactured by Shin-Nakamura Chemical Co., Ltd.)
   *2: The graft copolymer 1 is a polymer grafted by poly(oxy-1,2-ethanediyl), α-(2-methyl-1-oxo-2-propenyl)-ω-methoxy, and ethenylbenzene and is a dispersion containing 25% by mass of this polymer in a solvent containing n-propanol and water at a mass ratio of 80:20.
   *3: The graft copolymer 2 is a polymer particle of a graft copolymer containing poly(ethylene glycol)methyl ether methacrylate, styrene, and acrylonitrile at a ratio of 10:9:81 and is a dispersion containing 24% by mass of the polymer particles in a solvent containing n-propanol and water at a mass ratio of 80:20. The volume average particle diameter is 193 nm.
   *4: The mercapto-3-triazole indicates mercapto-3-triazole-1H,2,4, which is available from PCAS company (France).
   *5: Irgacure 250 is an iodonium salt which is available from Ciba Specialty Chemicals Corporation as a 75% propylene carbonate solution and contains iodonium and (4-methylphenyl)[4-(2-methylpropyl)phenyl]-hexafluorophosphate.
   *6: Klucel 99M is a hydroxypropyl cellulose thickener used as a 1% aqueous solution which is available from Hercules (Heverlee, Belgium).
   *7: Byk 336 is a modified dimethyl polysiloxane copolymer contained in a 25% xylene/methoxypropyl acetate solution, which is available from Byk Chemie GmbH.

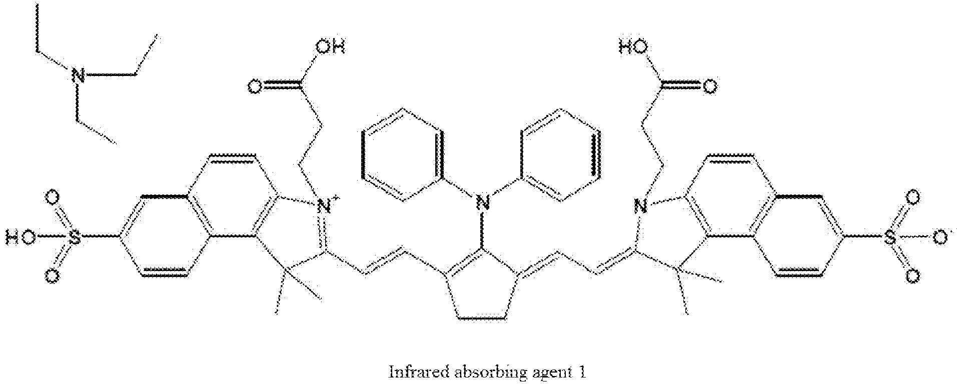

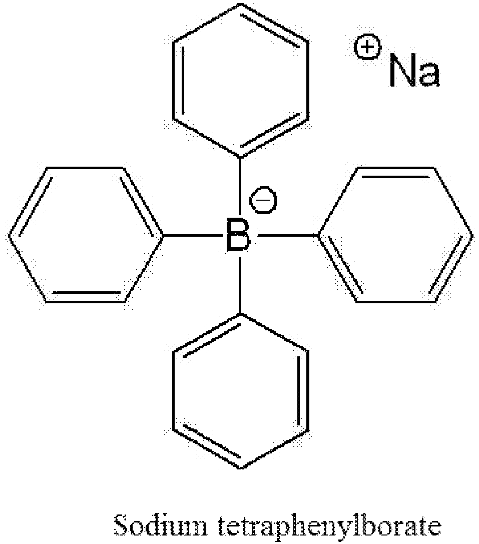

### <Synthesis of undercoat compound 1>

### - Purification of monomer M-1 -

420 parts of Light Ester P-1M (2-methacryloyloxyethyl acid phosphate, manufactured by KYOEISHA CHEMICAL CO., LTD.), 1050 parts of diethylene glycol dibutyl ether, and 1050 parts of distilled water were added to a separatory funnel, and the solution was vigorously stirred and then allowed to stand. The upper layer was disposed of, 1050 parts of diethylene glycol dibutyl ether was added to the separatory funnel, and the solution was vigorously stirred and then allowed to stand. The upper layer was disposed of, thereby obtaining 1300 parts of an aqueous solution (10.5% by mass in terms of solid content) containing a monomer M-1.

### - Synthesis of undercoat compound 1 -

53.73 parts of distilled water and 3.66 parts of the following monomer M-2 were added to a three-neck flask, and the solution was heated to 55°C in a nitrogen atmosphere. Next, the following dripping solution 1 was added dropwise thereto for 2 hours, the solution was stirred for 30 minutes, 0.386 parts of VA-046B (manufactured by Wako Pure Chemical Industries, Ltd.) was added thereto, and the solution was heated to 80°C and stirred for 1.5 hours. The temperature of the reaction solution was returned to room temperature (25°C), a 30 mass% sodium hydroxide aqueous solution was added thereto, the pH thereof was adjusted to 8.0, and 0.005 parts of 4-hydroxy-2,2,6,6-tetramethylpiperidine-1-oxyl (4-OH-TEMPO) was added thereto. By performing the above-described operation, 180 parts of an aqueous solution containing the undercoat compound 1 was obtained. The weight-average molecular weight (Mw) in terms of polyethylene glycol according to the gel permeation chromatography (GPC) method was 170000.

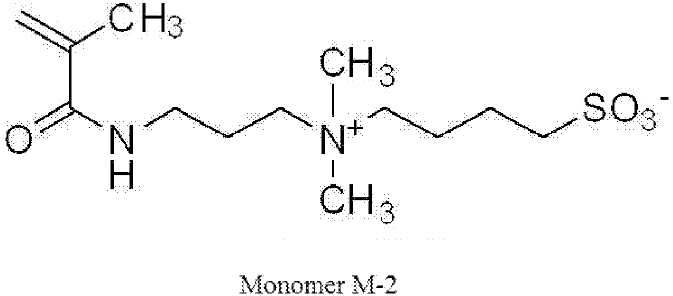

### <Dripping solution 1>

- Monomer M-1 aqueous solution described above: 87.59 parts
- Monomer M-2 described above: 14.63 parts
- VA-046B (2,2'-azobis[2-(2-imidazolin-2-yl)propane]disulfate dehydrate, manufactured by Wako Pure Chemical Industries, Ltd.): 0.386 parts
- Distilled water: 20.95 parts

### <Synthesis of graft copolymer 2>

A solution of 20 parts of polyethylene glycol methyl ether methacrylate (PEGMA) dissolved in a mixture of 50.5 parts of deionized water and 242.2 parts of n-propanol was added to a four-neck flask and slowly heated (to 73°C) until being slightly refluxed in a N₂ atmosphere. A pre-mixture of styrene (9 parts), acrylonitrile (81 parts), and VAZO-64 (0.7 parts) was added thereto for 2 hours. After 6 hours, 0.5 parts of VAZO-64 was further added thereto. The solution was heated to a temperature of 80°C. Next, 0.7 parts of VAZO-64 was added for 12 hours. After the reaction for a total of 20 hours, the conversion rate into a graft copolymer was greater than 98% based on the measurement of the non-volatile percentage. The mass ratio of PEGMA, styrene, and acrylonitrile was 10:9:81, and the ratio of n-propanol and water was 80:20. The number average particle diameter of the polymer particles was 200 nm.

Here, the average particle diameter is a value obtained by imaging an electron micrograph of polymer particles, measuring a total of 5000 particle diameters of particles on the photograph, and averaging the measured values.

### [Planographic printing plate precursor 2]

A planographic printing plate precursor 2 was prepared in the same manner as that for the planographic printing plate precursor 1 except that the support (1) of the planographic printing plate precursor 1 was changed to the following support (2).

### <Preparation of support (2)>

After an aluminum plate (material JIS 1052) having a thickness of 0.3 mm was subjected to the same treatment as the roughening treatment in the preparation of the support (1), the aluminum plate was subjected to an anodizing treatment at a treatment temperature of 38°C and a current density of 7.5 A/dm² using a 22 mass% phosphoric acid aqueous solution as an electrolytic solution.

Thereafter, the aluminum plate was washed with water using a spray. The final amount of the oxide film was 1.5 g/m². The surface of the substrate was imaged at a magnification of 150000 using an electronic microscope and the average pore diameter in a case of n = 90 was actually measured, and the value was 22 nm.

### [Planographic printing plate precursor 3]

A planographic printing plate precursor 3 was prepared in the same manner as that for the planographic printing plate precursor 1 except that the support (1) of the planographic printing plate precursor 1 was changed to the following support (3).

### <Preparation of support (3)>

After an aluminum plate (material JIS 1052) having a thickness of 0.3 mm was polished with a brush according to a conventional method, the aluminum plate was subjected to an anodizing treatment at a treatment temperature of 38°C and a current density of 15 A/dm² using a 22 mass% phosphoric acid aqueous solution as an electrolytic solution.

Thereafter, the aluminum plate was washed with water using a spray. The final amount of the oxide film was 1.5 g/m². After the oxide film was provided, the film was treated with an alkali at 30°C for 2 seconds using a 5% NaOH aqueous solution, thereby preparing a support (3). The surface of the substrate was imaged at a magnification of 150000 using an electronic microscope and the average pore diameter in a case of n = 90 was actually measured, and the value was 38 nm.

### [Planographic printing plate precursor 4]

A planographic printing plate precursor 4 was prepared in the same manner as that for the planographic printing plate precursor 1 except that the undercoat compound 1 of the above-described undercoat liquid (1) was changed to an undercoat compound 2 (the following structure).

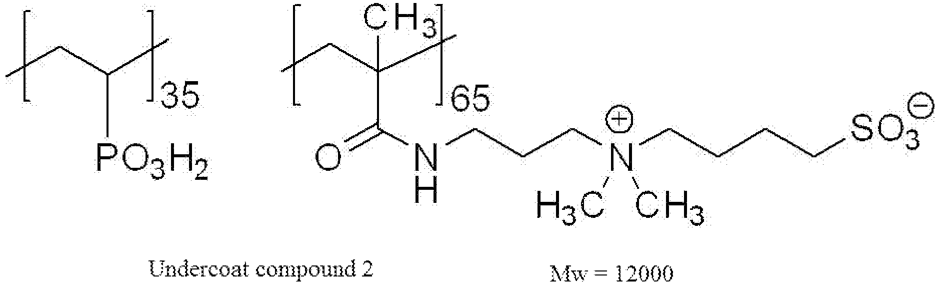

### <Synthesis of undercoat compound 2>

57.12 parts of distilled water and 45.71 parts of vinylphosphonic acid were added to a three-neck flask, and the solution was heated to 55°C in a nitrogen atmosphere. Next, the following dripping solution 2 was added dropwise thereto for 5 hours, the solution was stirred for 30 minutes, 2.702 parts of VA-046B (manufactured by Wako Pure Chemical Industries, Ltd.) was added thereto, and the solution was heated to 80°C and stirred for 1.5 hours. The temperature of the reaction solution was returned to room temperature, and 0.010 parts of 4-OH-TEMPO was added thereto. By performing the above-described operation, 300 parts of an aqueous solution containing the undercoat compound 2 was obtained. The weight-average molecular weight (Mw) in terms of polyethylene glycol according to the gel permeation chromatography (GPC) method was 12000.

### <Dripping solution 2>

- Monomer M-2 described above: 90.02 parts
- VA-046B (manufactured by Wako Pure Chemical Industries, Ltd.): 2.702 parts
- Distilled water: 103.88 parts

### [Planographic printing plate precursor 5]

A planographic printing plate precursor 5 was prepared in the same manner as that for the planographic printing plate precursor 1 except that the undercoat compound 1 of the above-described undercoat liquid (1) was changed to an undercoat compound 3 (the following structure).

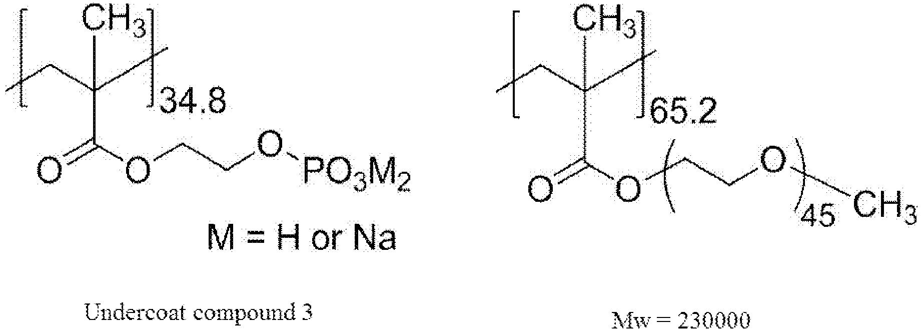

### <Synthesis of undercoat compound 3>

110.71 parts of distilled water was added to a three-neck flask and heated to 55°C in a nitrogen atmosphere. Next, the following dripping solution 3 was added dropwise thereto for 2 hours, the solution was stirred for 30 minutes, 0.386 parts of VA-046B (manufactured by Wako Pure Chemical Industries, Ltd.) was added thereto, and the solution was heated to 80°C and stirred for 1.5 hours. The temperature of the reaction solution was returned to room temperature, a 30 mass% sodium hydroxide aqueous solution was added thereto, the pH thereof was adjusted to 8.0, and 0.005 parts of 4-OH-TEMPO was added thereto. By performing the above-described operation, 370 parts of an aqueous solution containing the undercoat compound 3 was obtained. The weight-average molecular weight (Mw) in terms of polyethylene glycol according to the gel permeation chromatography (GPC) method was 230000.

### <Dripping solution 3>

- Monomer M-1 aqueous solution described above: 182.44 parts
- BLEMMER PME4000 (methoxypolyethylene glycol methacrylate, repetition number of oxyethylene units: 90, manufactured by NOF CORPORATION): 35.89 parts
- VA-046B (manufactured by Wako Pure Chemical Industries, Ltd.): 0.386 parts
- Distilled water: 42.32 parts

### [Planographic printing plate precursor 6]

A planographic printing plate precursor 6 was prepared in the same manner as that for the planographic printing plate precursor 1 except that the undercoat compound 1 of the above-described undercoat liquid (1) was changed to an undercoat compound 4 (the following structure).

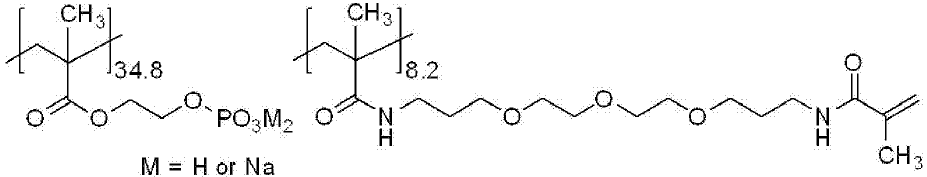

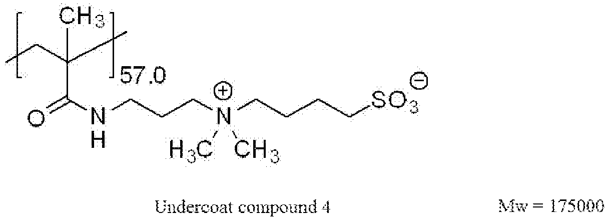

### <Synthesis of undercoat compound 4>

### - Synthesis of monomer M-3 -

200 parts (0.91 molar equivalent) of ANCAMINE 1922A (diethylene glycol di(aminopropyl) ether, manufactured by Air Products and Chemicals, Inc.), 435 parts of distilled water, and 410 parts of methanol were added to a three-neck flask, and the solution was cooled to 5°C. Next, 222.5 parts (1.82 molar equivalent) of benzoic acid and 0.025 parts (0.00015 molar equivalent) of 4-hydroxy-2,2,6,6-tetramethylpiperidine-1-oxyl (4-OH-TEMPO) were added thereto, and 280 parts (1.82 molar equivalent) of a methacrylic anhydride was added dropwise thereto such that the internal temperature of the reaction solution was set to 10°C or lower. After the reaction solution was stirred at 5°C for 6 hours and further stirred at 25°C for 12 hours, 70 parts of phosphoric acid was added to the solution and the pH thereof was adjusted to 3.3. The reaction solution was transferred to a stainless steel beaker, 3340 parts of ethyl acetate, 1110 parts of methyl-tert butyl ether (MTBE), and 650 parts of distilled water were added to the solution, and the solution was vigorously stirred and then allowed to stand. The upper layer (organic layer) was disposed of, 1620 parts of ethyl acetate was added thereto, the solution was vigorously stirred and then allowed to stand, and the upper layer was disposed of. Further, 1350 parts of ethyl acetate was added thereto, the solution was vigorously stirred and then allowed to stand, and the upper layer was disposed of. Thereafter, 1180 parts of MTBE was added thereto, the solution was vigorously stirred and then allowed to stand, and the upper layer was disposed of. 0.0625 parts (0.00036 molar equivalent) of 4-OH-TEMPO was added to the obtained aqueous solution, thereby obtaining 1200 parts of an aqueous solution (20.1% by mass in terms of solid content) containing a monomer M-3.

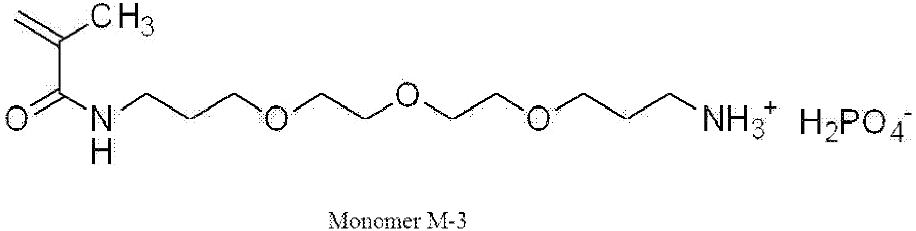

### - Synthesis of undercoat compound 4 -

52.92 parts of distilled water, 2.21 parts of a monomer M-3 aqueous solution, and 3.23 parts of the monomer M-2 were added to a three-neck flask, and the solution was heated to 55°C in a nitrogen atmosphere. Next, the following dripping solution 4 was added dropwise thereto for 2 hours, the solution was stirred for 30 minutes, 0.386 parts of VA-046B (manufactured by Wako Pure Chemical Industries, Ltd.) was added thereto, and the solution was heated to 80°C and stirred for 1.5 hours. The temperature of the reaction solution was returned to room temperature, a 30 mass% sodium hydroxide aqueous solution was added thereto, and the pH thereof was adjusted to 8.3. Next, 0.020 parts of 4-OH-TEMPO was added thereto, and the solution was heated to 53°C. 4.73 parts of a methacrylic anhydride was added thereto, and the solution was stirred at 53°C for 3 hours. The temperature of the reaction solution was returned to room temperature, the reaction solution was transferred to a separatory funnel, 180 parts of MTBE was added thereto, the solution was vigorously stirred and then allowed to stand, and the upper layer was disposed of. In the same manner as described above, a washing operation with 180 parts of MTBE was further repeated twice, 170 parts of distilled water and 0.020 parts of 4-OH-TEMPO were added to the obtained water layer, thereby obtaining 360 parts of an undercoat compound 4 as an aqueous solution. The weight-average molecular weight (Mw) in terms of polyethylene glycol according to the gel permeation chromatography (GPC) method was 175000.

### <Dripping solution 4>

- Monomer M-1 aqueous solution described above: 88.47 parts
- Monomer M-3 aqueous solution described above: 8.83 parts
- Monomer M-2 described above: 12.91 parts
- VA-046B (manufactured by Wako Pure Chemical Industries, Ltd.): 0.386 parts
- Distilled water: 14.98 parts

### [Planographic printing plate precursor 7]

A planographic printing plate precursor 7 was prepared in the same manner as that for the planographic printing plate precursor 1 except that the undercoat compound 1 of the above-described undercoat liquid (1) was changed to an undercoat compound 5 (the following structure).

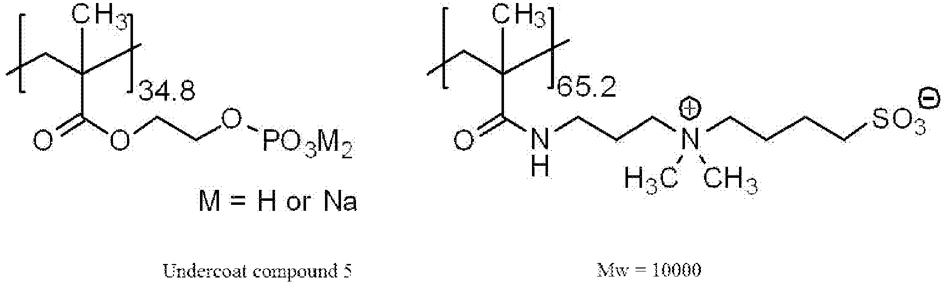

### <Synthesis of undercoat compound 5>

The undercoat compound 5 was obtained in the same manner as in the synthesis of the undercoat compound 1 except that the amount of VA-046B to be added was changed from 0.386 parts to 4.343 parts, the amount of VA-046B in the dripping solution 1 was changed from 0.386 parts to 4.343 parts, and the reaction temperature was changed from 55°C to 65°C. The weight-average molecular weight (Mw) in terms of polyethylene glycol according to the gel permeation chromatography (GPC) method was 10000.

### [Planographic printing plate precursor 8]

A planographic printing plate precursor 8 was prepared in the same manner as that for the planographic printing plate precursor 1 except that the undercoat compound 1 of the above-described undercoat liquid (1) was changed to an undercoat compound 6 (the following structure).

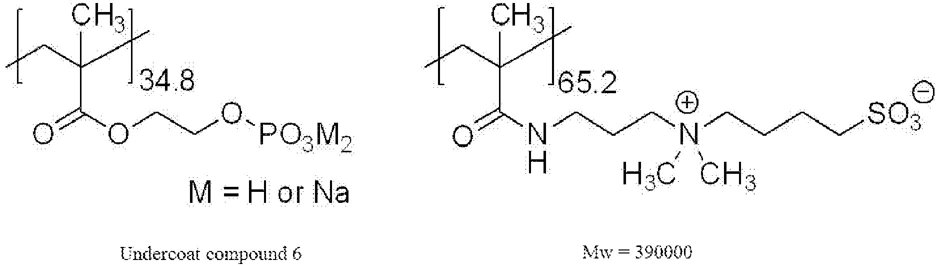

### <Synthesis of undercoat compound 6>

The undercoat compound 6 was obtained in the same manner as in the synthesis of the undercoat compound 1 except that the amount of VA-046B to be added was changed from 0.386 parts to 0.290 parts, the amount of VA-046B in the dripping solution 1 was changed from 0.386 parts to 0.290 parts, and the reaction temperature was changed from 55°C to 50°C. The weight-average molecular weight (Mw) in terms of polyethylene glycol according to the gel permeation chromatography (GPC) method was 390000.

### [Planographic printing plate precursor 9]

A planographic printing plate precursor 9 was prepared in the same manner as that for the planographic printing plate precursor 1 except that the polymerizable compound 1 of the above-described image forming layer coating solution (1) was changed to a polymerizable compound 2 (the following structure).

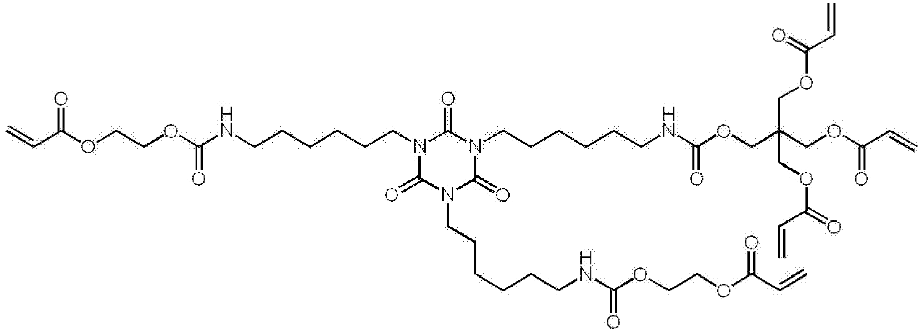

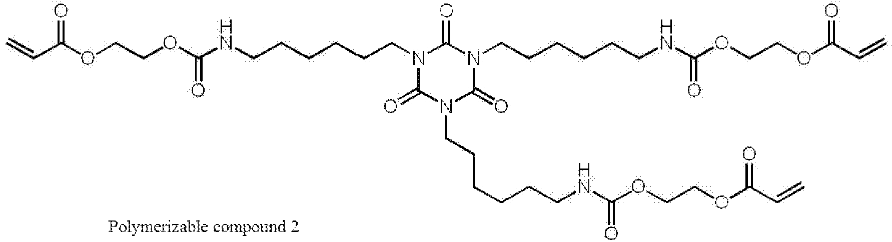

### [Planographic printing plate precursors 10 to 13]

Planographic printing plate precursors 10 to 13 were prepared in the same manner as that for the planographic printing plate precursor 1 except that the particle diameter of the graft copolymer was changed by changing the compositional ratio of poly(ethylene glycol)methyl ether methacrylate in the synthesis of the graft copolymer 2 of the image forming layer coating solution (1).

### [Planographic printing plate precursor 14]

A planographic printing plate precursor 14 was prepared in the same manner as that for the planographic printing plate precursor 1 except that the graft copolymer 2 of the above-described image forming layer coating solution (1) was changed to a graft copolymer 3.

### <Synthesis of graft copolymer 3>

The graft copolymer 3 was synthesized in the same manner as in the synthesis of the graft copolymer 2 except that PEGMA was not added and the amount of styrene to be added and the amount of acrylonitrile to be added were respectively changed to 20 parts and 80 parts.

### [Planographic printing plate precursor 15]

A planographic printing plate precursor 15 was prepared in the same manner as that for the planographic printing plate precursor 1 except that the graft copolymer 2 of the above-described image forming layer coating solution (1) was changed to a graft copolymer 4.

### <Synthesis of graft copolymer 4>

The graft copolymer 4 was synthesized in the same manner as in the synthesis of the graft copolymer 2 except that PEGMA and acrylonitrile were not added and the amount of styrene to be added was changed to 100 parts.

### [Planographic printing plate precursor 16]

A planographic printing plate precursor 16 was prepared in the same manner as that for the planographic printing plate precursor 1 except that the undercoat compound 1 of the undercoat liquid (1) was changed to the undercoat compound 4 and the graft copolymer 2 of the above-described image forming layer coating solution (1) was changed to the graft copolymer 3.

### [Planographic printing plate precursor 17]

A planographic printing plate precursor 17 was prepared in the same manner as that for the planographic printing plate precursor 1 except that the undercoat compound 1 of the undercoat liquid (1) was changed to the undercoat compound 4 and the polymerizable compound 1 of the above-described image forming layer coating solution (1) was changed to the polymerizable compound 2.

### [Planographic printing plate precursor 18]

### (1) Preparation of support (4)

In order to remove rolling oil on a surface of an aluminum plate (Material JIS A 1050) having a thickness of 0.3 mm, a degreasing treatment was performed using a 10 mass% sodium aluminate aqueous solution at 50°C for 30 seconds, the aluminum surface was grained using three bundle nylon brushes having a bristle diameter of 0.3 mm and a pumice water suspension (specific gravity of 1.1 g/cm³) having a median diameter of 25 µm and then sufficiently washed with water. This aluminum plate was immersed in a 25 mass% sodium hydroxide aqueous solution at 45°C for 9 seconds, etched, washed with water, and further immersed in 20 mass% nitric acid at 60°C for 20 seconds, and then washed with water. The etching amount of the grained surface at this time was approximately 3 g/m².

Next, an electrochemical roughening treatment was continuously performed using an AC voltage of 60 Hz. As the electrolytic solution, a 1 mass% nitric acid aqueous solution (including 0.5% by mass of aluminum ions) was used at a liquid temperature of 50°C. Using a trapezoidal rectangular waveform AC having a time TP, until the current value reached a peak from zero, of 0.8 msec and the duty ratio of 1:1 as an AC power source waveform, the electrochemical surface-roughening treatment was performed using a carbon electrode as a counter electrode. As an auxiliary anode, ferrite was used. The current density was 30 A/dm² as the peak current value, and 5% of the current flowing from the power source was separated to an auxiliary anode. The electric quantity in the nitric acid electrolysis was 175 C/dm² in a case where the aluminum plate was an anode. Thereafter, washing with water was performed using a spray.

Next, an electrochemical roughening treatment was performed according to the same method as the method for nitric acid electrolysis under the condition of an electric quantity of 50 C/dm² in a case where an aluminum plate is an anode in a 0.5 mass% hydrochloric acid aqueous solution (including 0.5% by mass of aluminum ions) and an electrolytic solution at a liquid temperature of 50°C. Subsequently, washing with water using a spray was performed. Next, 2.5 g/m² of a DC anodized film was provided on this aluminum plate at a current density of 15 A/dm² using 15 mass% nitric acid (including 0.5% by mass of aluminum ions) as an electrolytic solution, washed with water, and then dried.

Thereafter, in order to ensure the hydrophilicity of the non-image area, a silicate treatment was performed at 70°C for 12 seconds using a 1.5 mass% No. 3 sodium silicate aqueous solution. The adhesion amount of Si was 6 mg/m². Subsequently, the film was washed with water, thereby obtaining a support (4).

The surface of the substrate was imaged at a magnification of 150000 using fluorescent X-rays and the average pore diameter in a case of n = 90 was actually measured, and the value was 8 nm.

The support (4) was coated with the following undercoat liquid (2) such that the dried coating amount thereof was set to 20 mg/m² and dried in an oven at 100°C for 30 seconds to form an undercoat layer.

### <Undercoat liquid (2)>

- Undercoat compound 7 shown below: 0.18 parts
- Methanol: 55.24 parts
- Distilled water: 6.15 parts

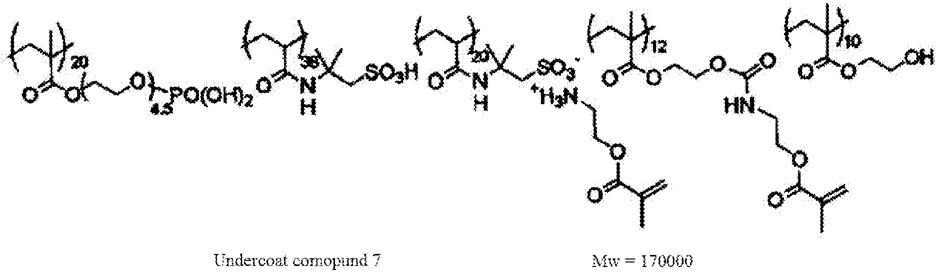

### <Synthesis of undercoat compound 7>

The undercoat compound 7 was synthesized using the undercoat compound (1) described in JP2010-26006A.

### (2) Formation of image forming layer

The support including an undercoat layer was bar-coated with an image forming layer coating solution (2) with the following composition and dried in an oven at 100°C for 60 seconds to form an image forming layer having a dried coating amount of 1.0 g/m².

### <Image forming layer coating solution (2)>

- Binder polymer (1) [the following structure]: 0.240 parts
- Infrared absorbing agent (2) [the following structure]: 0.030 parts
- Polymerization initiator (1) [the following structure]: 0.162 parts
- Polymerizable compound (tris(acryloyloxyethyl)isocyanurate, NK Ester A-9300, manufactured by Shin-Nakamura Chemical Co., Ltd.): 0.192 parts
- Tris(2-hydroxyethyl)isocyanurate: 0.062 parts
- Benzyl-dimethyl-octylammonium and PF₆ salt: 0.018 parts
- Ammonium group-containing polymer [the structure of the following reference numeral (15)]: 0.010 parts
- Fluorine-based surfactant (1) [the following structure]: 0.008 parts
- Methyl ethyl ketone: 1.091 parts
- 1-methoxy-2-propanol: 8.609 parts
- Polymer particle (hydrophobic precursor) aqueous dispersion liquid: 5.065 parts

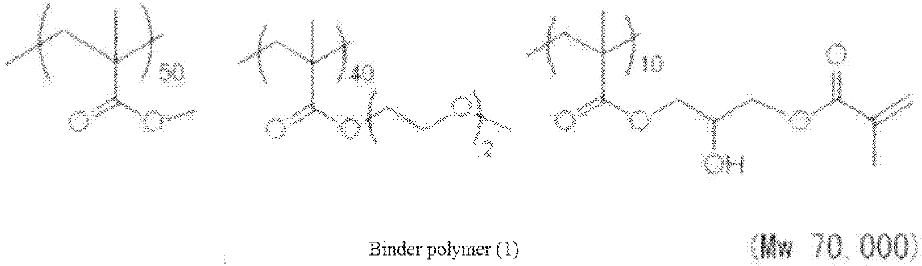

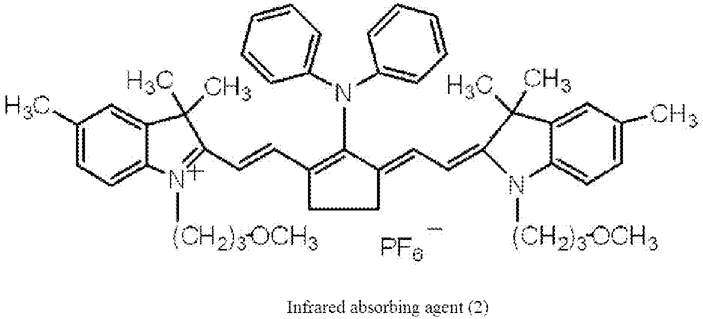

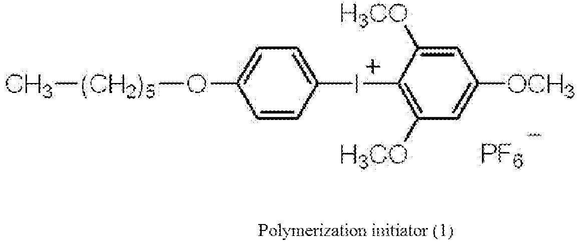

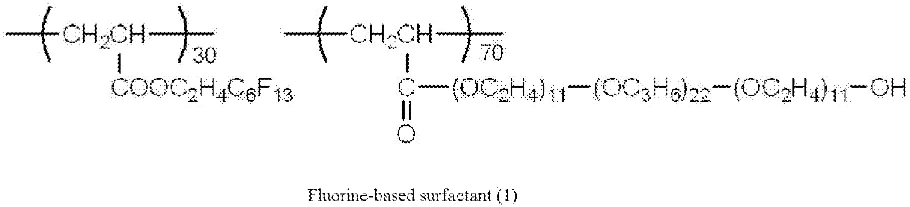

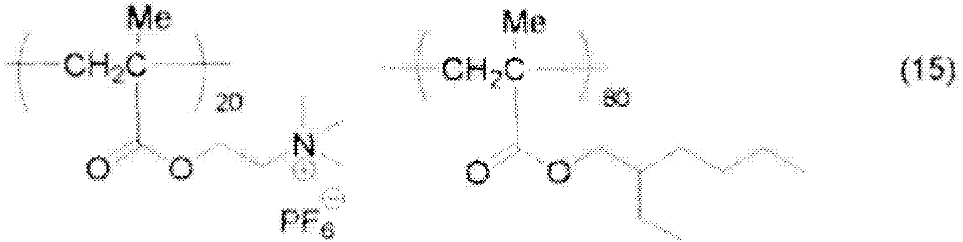

### Further, Me represents a methyl group.

### <Production of polymer particle (hydrophobic precursor) aqueous dispersion liquid>

A nitrogen gas was introduced to a four-neck flask equipped with a stirrer, a thermometer, a dropping funnel, a nitrogen introduction pipe, and a reflux condenser, 350 parts of distilled water was added thereto while deoxidation was performed, and the flask was heated until the internal temperature was set to 80°C. 3.0 parts of sodium dodecyl sulfate was added thereto as a dispersant, 0.45 parts of ammonium persulfate was further added thereto as an initiator, and then a mixture of 22.0 parts of acrylonitrile, 20.0 parts of glycidyl methacrylate, and 20.0 parts of styrene was added dropwise thereto from the dropping funnel for 1 hour. After completion of the dropwise addition, the reaction was continued as it was for 5 hours so that unreacted monomers were removed by steam distillation. Thereafter, the reaction solution was cooled, the pH thereof was adjusted to 6 using ammonia water, and pure water was added so that the final non-volatile content became 15% by mass, thereby obtaining a polymer particle (hydrophobic precursor) aqueous dispersion liquid. The particle size distribution of the polymer particles had a maximum value at a particle diameter of 155 nm.

Here, the particle size distribution was acquired by imaging an electron micrograph of the polymer particles, measuring a total of 5000 particle diameters of fine particles on the photograph, dividing the interval from the maximum value of the obtained measured value of the particle diameter to 0 into the logarithmic scale of 50, and plotting the appearance frequency of each particle diameter. Further, the particle diameter of a spherical particle having the same particle area as the particle area on the photograph was set to the particle diameter, as non-spherical particles.

### (3) Formation of protective layer

The image forming layer was bar-coated with a protective layer coating solution (1) with the following composition and dried in an oven at 120°C for 60 seconds to form a protective layer having a dried coating amount of 0.15 g/m², thereby obtaining a planographic printing plate precursor 18.

### <Protective layer coating solution (1)>

- Inorganic layered compound dispersion liquid (1) prepared in the following manner: 1.5 parts
- Polyvinyl alcohol (CKS50, manufactured by Nippon Synthetic Chemical Industry Co., Ltd., sulfonic acid-modified, saponification degree: 99% by mole or greater, degree of polymerization: 300), 6 mass% aqueous solution: 0.55 parts
   Polyvinyl alcohol (PVA-405, manufactured by KURARAY CO., LTD., saponification degree: 81.5% by mole, degree of polymerization: 500), 6 mass% aqueous solution: 0.03 parts
- Surfactant (EMALEX 710, manufactured by Nihon Emulsion Co., Ltd., 1 mass% aqueous solution): 8.60 parts
- Ion exchange water: 6.0 parts

### <Preparation of inorganic layered compound dispersion liquid (1)>

6.4 parts of synthetic mica Somasif ME-100 (manufactured by CO-OP CHEMICAL CO., LTD.) was added to 193.6 parts of ion exchange water and dispersed such that the average particle diameter (laser scattering method) was set to 3 µm using a homogenizer. The aspect ratio of the obtained dispersed particles was 100 or greater.

### [Planographic printing plate precursor 19]

### (1) Preparation of support (5)

A support (5) was prepared by treating the support (1) of the planographic printing plate precursor 1 with polyacrylic acid.

### (2) Formation of image forming layer

The support (5) was not coated with an undercoat liquid and was bar-coated with an image forming layer coating solution (3) with the following composition and dried in an oven at 94°C for 60 seconds to form an image forming layer having a dried coating amount of 1.5 g/m².

### <Image forming layer coating solution (3)>

- Urethane acrylate 1 *1: 0.325 parts
- Graft copolymer 1 *2: 0.060 parts
- Graft copolymer 2 *3: 0.198 parts
- Mercapto-3-triazole *4: 0.180 parts
- Ammonium group-containing polymer (the structure of the following reference numeral (15)): 0.005 parts
- Irgacure 250 *5: 0.032 parts
- Infrared absorbing agent 3 (the following structure): 0.007 parts
- Klucel 99M *6: 0.007 parts
- Byk 336 *7: 0.015 parts
- n-Propanol: 7.470 parts
- Water: 1.868 parts
   *1: Urethane acrylate 1 was prepared by reacting Desmodur N100 (an aliphatic polyisocyanate resin which is available from Bayer AG and uses hexamethylene diisocyanate as a main agent) with hydroxyethyl acrylate and pentaerythritol triacrylate.
   *2: The graft copolymer 1 is a polymer grafted by poly(oxy-1,2-ethanediyl), α-(2-methyl-1-oxo-2-propenyl)-ω-methoxy, and ethenylbenzene and is a dispersion containing 25% by mass of this polymer in a solvent containing n-propanol and water at a mass ratio of 80:20.
   *3: The graft copolymer 2 is a polymer particle of a graft copolymer containing methoxy polyethylene glycol methacrylate, styrene, and acrylonitrile at a ratio of 10:9:81 and is a dispersion containing 24% by mass of the polymer particles in a solvent containing n-propanol and water at a mass ratio of 80:20. The volume average particle diameter is 193 nm.
   *4: The mercapto-3-triazole indicates mercapto-3-triazole-1H,2,4, which is available from PCAS company (France).
   *5: Irgacure 250 is an iodonium salt which is available from Ciba Specialty Chemicals Corporation as a 75% propylene carbonate solution and contains iodonium and (4-methylphenyl)[4-(2-methylpropyl)phenyl]-hexafluorophosphate.
   *6: Klucel 99M is a hydroxypropyl cellulose thickener used as a 1% aqueous solution which is available from Hercules (Heverlee, Belgium).
   *7: Byk 336 is a modified dimethyl polysiloxane copolymer contained in a 25% xylene/methoxypropyl acetate solution, which is available from Byk Chemie GmbH.

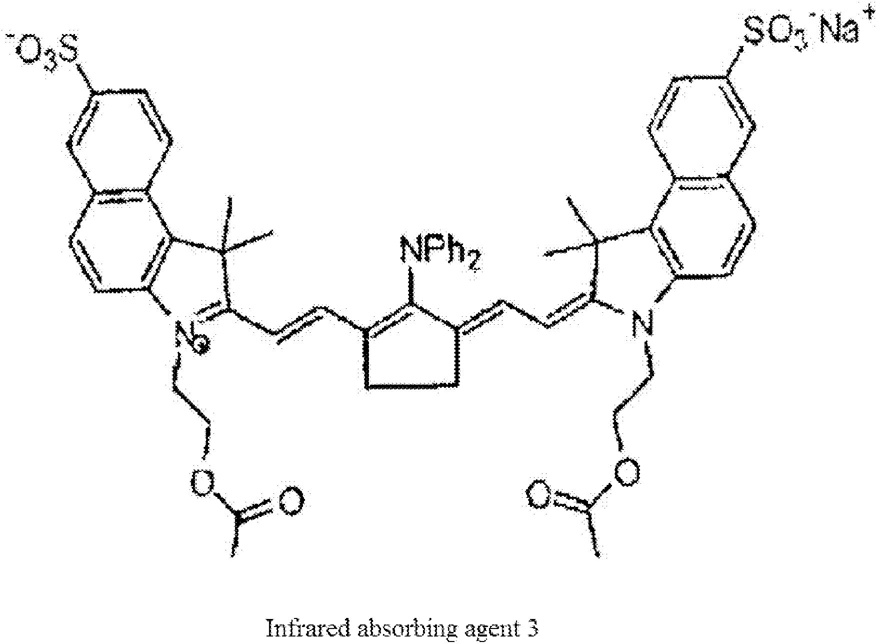

Further, Ph represents a phenyl group.

### [Planographic printing plate precursor 20]

### (1) Preparation of support

The support (5) was bar-coated with the undercoat liquid (2) such that the dried coating amount was set to 20 mg/m² and dried in an oven at 100°C for 30 seconds to form an undercoat layer.

### (2) Preparation of image forming layer

The support including an undercoat layer was bar-coated with an image forming layer coating solution (4) with the following composition and dried in an oven at 100°C for 60 seconds to form an image forming layer having a dried coating amount of 1.0 g/m². Here, a microgel liquid (1) which is a composition of the image forming layer coating solution (4) was added and stirred immediately before the coating.

### <Image forming layer coating solution (4)>

- Binder polymer (1) [the above-described structure]: 0.240 parts
- Infrared absorbing agent (2) [the above-described structure]: 0.030 parts
- Polymerization initiator (1) [the above-described structure]: 0.162 parts
- Polymerizable compound (tris(acryloyloxyethyl)isocyanurate, NK Ester A-9300, manufactured by Shin-Nakamura Chemical Co., Ltd.): 0.192 parts
- Tris(2-hydroxyethyl)isocyanurate: 0.062 parts
- Benzyl-dimethyl-octylammonium and PF₆ salt: 0.018 parts
- Ammonium group-containing polymer (the structure of the above-described reference numeral (15)): 0.010 parts
- Fluorine-based surfactant (1) [the above-described structure]: 0.008 parts
- Methyl ethyl ketone: 1.091 parts
- 1-methoxy-2-propanol: 8.609 parts
- Microgel liquid (1) [with the following composition]: 5.065 parts

### <Microgel liquid (1)>

- Microgel (1) [the following synthesis method]: 2.640 parts
- Distilled water: 2.425 parts

### <Synthesis of microgel (1)>

As oil phase components, 10 parts of an adduct (TAKENATE D-110N, manufactured by Mitsui Takeda Chemicals Inc.) of trimethylolpropane and xylene diisocyanate, 3.15 parts of pentaerythritol triacrylate (SR444, manufactured by Nippon Kayaku Co., Ltd.), and 0.1 parts of PIONIN A-41C (manufactured by Takemoto Oil & Fat Ltd.) were dissolved in 17 parts of ethyl acetate. As water phase components, 40 parts of a 4 mass% aqueous solution of PVA-205 was prepared. The oil phase components and the water phase components were mixed and emulsified at 12000 rpm for 10 minutes using a homogenizer. The obtained emulsified product was added to 25 g of distilled water, stirred at room temperature (25°C) for 30 minutes, and stirred at 50°C for 3 hours. The microgel liquid obtained in the above-described manner was diluted with distilled water such that concentration of solid contents thereof was set to 15% by mass. The average particle diameter thereof was 0.2 µm.

### (3) Preparation of protective layer

The image forming layer was bar-coated with the protective layer coating solution (1) with the above-described composition and dried in an oven at 120°C for 60 seconds to form a protective layer having a dried coating amount of 0.15 g/m², thereby obtaining a planographic printing plate precursor 20.

### [Planographic printing plate precursor 21]

A planographic printing plate precursor 21 was prepared in the same manner as that for the planographic printing plate precursor 19 except that the image forming layer coating solution (3) of the planographic printing plate precursor 19 was changed to the image forming layer coating solution (4) and the protective layer was formed using the protective layer coating solution (1).

### [Planographic printing plate precursor 22]

A planographic printing plate precursor 22 was prepared in the same manner as that for the planographic printing plate precursor 1 except that the support (1) of the planographic printing plate precursor 1 was changed to the following support (6).

### <Preparation of support (6)>

After an aluminum plate (material JIS 1052) having a thickness of 0.3 mm was subjected to the same treatment as the roughening treatment in the preparation of the support (1), the aluminum plate was subjected to an anodizing treatment at a treatment temperature of 38°C and a current density of 15 A/dm² using a 22 mass% phosphoric acid aqueous solution as a electrolytic solution.

Thereafter, the aluminum plate was washed with water using a spray. The final amount of the oxide film was 1.5 g/m². After the oxide film was provided, the film was treated with an alkali at 35°C for 2 seconds using a 5% NaOH aqueous solution, thereby preparing a support (6).

The surface of the substrate was imaged at a magnification of 150000 using an electronic microscope and the average pore diameter in a case of n = 90 was actually measured, and the value was 50 nm.

### [Planographic printing plate precursor 23]

A planographic printing plate precursor 23 was prepared in the same manner as that for the planographic printing plate precursor 1 except that the undercoat compound 1 of the above-described planographic printing plate precursor 1 was changed to an undercoat compound 8.

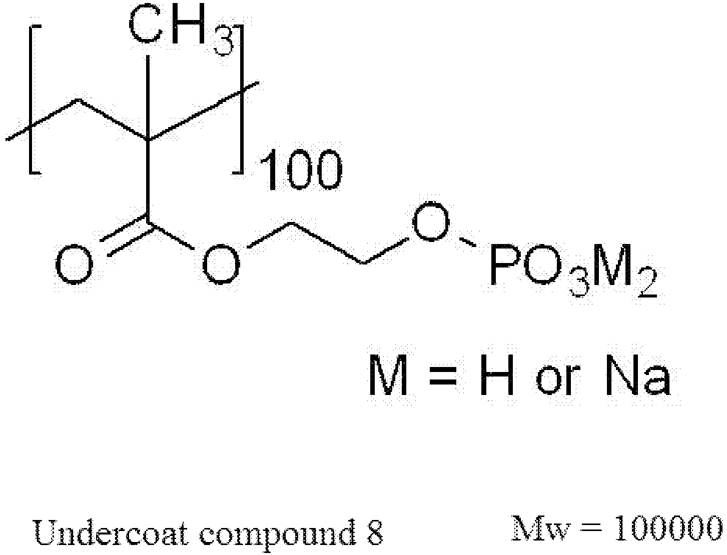

### <Synthesis of undercoat compound 8>

17.20 parts of distilled water was added to a three-neck flask and heated to 55°C in a nitrogen atmosphere. Next, the following dripping solution A was added dropwise thereto for 2 hours, the solution was stirred for 30 minutes, 0.193 parts of VA-046B (manufactured by Wako Pure Chemical Industries, Ltd.) was added thereto, and the solution was heated to 80°C and stirred for 1.5 hours. The temperature of the reaction solution was returned to room temperature, a 30 mass% sodium hydroxide aqueous solution was added thereto, the pH thereof was adjusted to 8.0, and 0.005 parts of 4-OH-TEMPO was added thereto. By performing the above-described operation, 151 parts of an aqueous solution containing the undercoat compound 8 was obtained. The weight-average molecular weight (Mw) in terms of polyethylene glycol according to the gel permeation chromatography (GPC) method was 100000.

### <Dripping solution A>

- Monomer M-1 aqueous solution described above: 100.06 parts
- VA-046B (manufactured by Wako Pure Chemical Industries, Ltd.): 0.193 parts
- Distilled water: 32.83 parts

### [Planographic printing plate precursor 24]

A planographic printing plate precursor 24 was prepared in the same manner as that for the planographic printing plate precursor 1 except that the undercoat compound 1 of the above-described planographic printing plate precursor 1 was changed to an undercoat compound 9.

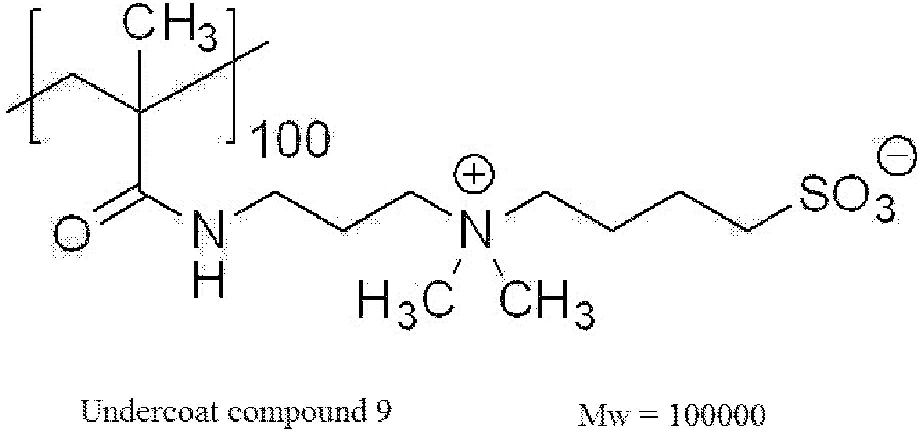

### <Synthesis of undercoat compound 9>

26.33 parts of distilled water and 4.34 parts of the monomer M-2 were added to a three-neck flask and the solution was heated to 55°C in a nitrogen atmosphere. Next, the following dripping solution B was added dropwise thereto for 2 hours, the solution was stirred for 30 minutes, 0.309 parts of VA-046B (manufactured by Wako Pure Chemical Industries, Ltd.) was added thereto, and the solution was heated to 80°C and stirred for 1.5 hours. The temperature of the reaction solution was returned to room temperature, a 30 mass% sodium hydroxide aqueous solution was added thereto, the pH thereof was adjusted to 8.0, and 0.005 parts of 4-OH-TEMPO was added thereto. By performing the above-described operation, 155 parts of an aqueous solution containing the undercoat compound 9 was obtained. The weight-average molecular weight (Mw) in terms of polyethylene glycol according to the gel permeation chromatography (GPC) method was 100000.

### <Dripping solution A>

- Monomer M-2 described above: 17.36 parts
- VA-046B (manufactured by Wako Pure Chemical Industries, Ltd.): 0.309 parts
- Distilled water: 107.13 parts

### [Plate-making]

The printing plate precursors for on-press development were exposed using Luxel PLATESETTER T-6000III (manufactured by Fujifilm Corporation) equipped with an infrared semiconductor laser under conditions of an external surface drum rotation speed of 1000 rpm, a laser output of 70%, and a resolution of 2,400 dpi (dot per inch). The exposure was carried out such that the exposed image had a solid image, 3% halftone dots of TAFFETA20 (FM screen), and a Ming-type 7 point-sized cutout character chart. In addition, 1 inch is 25.4 mm.

A printing press LITHRONE26 (manufactured by KOMORI Corporation) was attached to the plate cylinder without performing the development treatment on each of the obtained exposed precursors. Dampening water and ink were supplied using a standard automatic printing start method for LITHRONE26 using dampening water, in which the volume ratio of Ecolity-2 (manufactured by Fujifilm Corporation) to tap water was 2:98, and Values-G (N) black ink (manufactured by DIC Corporation) to perform on-press development, and then printing was performed on Tokubishi Art (ream weight of 76.5 kg) paper at a printing speed of 10000 sheets per hour.

### [Evaluation]

### (1) Printing durability

After the on-press development was performed, printing was further carried out. Since the image forming layer was gradually worn out as the number of printed sheets increased, the ink density on the printed material decreased. The timing at which the value obtained by measuring the halftone dot area ratio of 3% halftone dots of the FM screen in the printed material using a gretag densitometer was smaller than the measured value for the 100-th printed sheet by 5% was regarded as completion of printing, and the printing durability was evaluated with the number of print copies. The results are listed in Table 1.

### (2) Standing fouling resistance after standing on machine

After the above-described on-press development was performed, and the printing was continuously performed on 10000 sheets. Next, the printing press was stopped and restarted after one hour.

At this time, the standing fouling resistance was evaluated by visually observing the number of printed sheets at which the stain in cutout characters on the printed material was recovered. The results are listed in Table 1.

### (3) On-press developability with time

30 sheets of interleaving paper for preventing scratches were prepared in a state in which each interleaving paper was interposed between planographic printing plate precursors, the upper and lower precursors were interposed in cardboard, and then the resultant was packaged with paper coated with aluminum. This package was stored at 25°C for 6 months. Thereafter, the package was opened to take out planographic printing plate precursors, and the exposure and the printing were started in the above-described manner. The on-press development applied to the unexposed portion of the image forming layer on the printing press was completed, and the number of sheets of printing paper required until the ink was not transferred to the non-image area any more was measured as the on-press developability.

The results are listed in Table 1

**[Table 1]**

| | | Support | Compound contained in interlayer | | | | Image recording layer | | | | | Evaluation | | |
|---|---|---|---|---|---|---|---|---|---|---|---|---|---|---|
| | | Average pore diameter (nm) | Support absorptive group | Hydrophilic group | Other groups | Mw (×10000) | Infrared absorbing agent | Polymerization initiator | Polymerizable compound | Polymer particles | | Printing durability (1000 sheets) | Standing fouling resistance (sheets) | On-press developability with time (sheets) |
| | | | | | | | | | | Number average particle diameter (nm) | Composition | | | |
| Example 1 | Precursor 1 | 30 | Phosphoric acid | Betaine | Not available | 17 | Available | Available | Available | 200 | PEGMA/ST/AN | 30 | 60 | 20 |
| Example 2 | Precursor 2 | 22 | Phosphoric acid | Betaine | Not available | 17 | Available | Available | Available | 200 | PEGMA/ST/AN | 25 | 55 | 20 |
| Example 3 | Precursor 3 | 38 | Phosphoric acid | Betaine | Not available | 17 | Available | Available | Available | 200 | PEGMA/ST/AN | 30 | 65 | 25 |
| Example 4 | Precursor 4 | 30 | Phosphonic acid | Betaine | Not available | 10 | Available | Available | Available | 200 | PEGMA/ST/AN | 25 | 65 | 20 |
| Example 5 | Precursor 5 | 30 | Phosphoric acid | Oxyalkylene | Not available | 23 | Available | Available | Available | 200 | PEGMA/ST/AN | 30 | 65 | 20 |
| Example 6 | Precursor 6 | 30 | Phosphoric acid | Betaine | C=C group | 17.5 | Available | Available | Available | 200 | PEGMA/ST/AN | 35 | 60 | 20 |
| Example 7 | Precursor 7 | 30 | Phosphoric acid | Betaine | Not available | 0.55 | Available | Available | Available | 200 | PEGMA/ST/AN | 30 | 65 | 20 |
| Example 8 | Precursor 8 | 30 | Phosphoric acid | Betaine | Not available | 39 | Available | Available | Available | 200 | PEGMA/ST/AN | 30 | 55 | 20 |
| Example 9 | Precursor 9 | 30 | Phosphoric acid | Betaine | Not available | 17 | Available | Available | Available (urethane bond) | 200 | PEGMA/ST/AN | 35 | 60 | 20 |
| Example 10 | Precursor | 30 | Phosphoric acid | Betaine | Not available | 17 | Available | Available | Available | 80 | PEGMA/ST/AN | 25 | 60 | 35 |
| Example 11 | Precursor 11 | 30 | Phosphoric acid | Betaine | Not available | 17 | Available | Available | Available | 110 | PEGMA/ST/AN | 30 | 60 | 20 |
| Example 12 | Precursor | 30 | Phosphoric acid | Betaine | Not available | 17 | Available | Available | Available | 280 | PEGMA/ST/AN | 30 | 60 | 20 |
| Example 13 | Precursor | 30 | Phosphoric acid | Betaine | Not available | 17 | Available | Available | Available | 350 | PEGMA/ST/AN | 25 | 60 | 20 |
| Example 14 | Precursor | 30 | Phosphoric acid | Betaine | Not available | 17 | Available | Available | Available | 200 | ST/AN | 30 | 60 | 20 |
| Example 15 | Precursor | 30 | Phosphoric acid | Betaine | Not available | 17 | Available | Available | Available | 200 | ST | 30 | 60 | 30 |
| Example 16 | Precursor | 30 | Phosphoric acid | Betaine | C=C group | 17.5 | Available | Available | Available | 200 | ST/AN | 35 | 60 | 20 |
| Example 17 | Precursor | 30 | Phosphoric acid | Betaine | C=C group | 17.5 | Available | Available | Available (urethane bond) | 200 | PEGMA/ST/AN | 38 | 60 | 20 |
| Comparative Example 1 | Pre cusor 18 | 7 | Phosphoric acid | Betaine | C=C group | 17 | Available | Available | Available | 200 | PEGMA/ST/AN | 10 | 60 | 20 |
| Comparative Example 2 | Precursor 19 | 30 | Not available | Not available | Not available | 17 | Available | Available | Available | 200 | PEGMA/ST/AN | 30 | 100 or greater | 50 or greater |
| Comparative Example 3 | Precursor 20 | 30 | Phosphoric acid | Betaine | C=C group | 17 | Available | Available | Available | Not available | Not available | 10 | 60 | 20 |
| Comparative Example 4 | Precursor 21 | 30 | Not available | Not available | Not available | 17 | Available | Available | Available | Not available | Not available | 10 | 100 or greater | 50 or greater |
| Comparative Example 5 | Precursor 22 | 50 | Phosphoric acid | Betaine | Not available | 17 | Available | Available | Available | 200 | PEGMA/ST/AN | 30 | 100 or greater | 30 |
| Comparative Example 6 | Precursor 23 | 30 | Phosphoric acid | Not available | Not available | 10 | Available | Available | Available | 200 | PEGMA/ST/AN | 30 | 100 or greater | 20 |
| Comparative Example 7 | Precursor 24 | 30 | Not available | Betaine | Not available | 10 | Available | Available | Available | 200 | PEGMA/ST/AN | 10 | 100 or greater | 50 or greater |

As understood from the results listed in Table 1, according to the present disclosure, a planographic printing plate having excellent printing durability, standing fouling resistance, and on-press developability with time was able to be provided.

## Claims

1. A planographic printing plate precursor for on-press development, comprising:
an aluminum support;
an interlayer which contains a compound containing a support absorptive group and a hydrophilic group; and
an image recording layer which contains an infrared absorbing agent, a polymerization initiator, a polymerizable compound, and polymer particles formed of a styrene copolymer, on the aluminum support,
wherein the aluminum support is an aluminum plate having an anodized film on a surface in contact with the interlayer and the anodized film has micropores extending in a depth direction from a surface in contact with the interlayer,
an average pore diameter of the micropores in the surface of the anodized film is in a range of 20 to 40 nm, and
the styrene copolymer is a copolymer of a styrene-(meth)acrylonitrile-poly(ethylene glycol)monoalkylether (meth)acrylate compound,
the hydrophilic group has a structure selected from the group consisting of a betaine structure (zwitterion), a polyalkyleneoxy structure, a sulfonic acid group, a sulfonate group, a carboxylic acid group, and a carboxylate group, and
the support absorptive group has a structure selected from the group consisting of a phosphonic acid structure, a phosphonate structure, a phosphoric acid ester structure, and a phosphoric acid ester salt structure.

2. The planographic printing plate precursor for on-press development according to claim 1,
wherein the hydrophilic group has a betaine structure.

3. The planographic printing plate precursor for on-press development according to claim 1 or 2,
wherein the compound containing a support absorptive group and a hydrophilic group further contains a polymerizable group.

4. The planographic printing plate precursor for on-press development according to any one of claims 1 to 3,
wherein a number average particle diameter of the polymer particles is in a range of 100 to 300 nm.

5. The planographic printing plate precursor for on-press development according to any one of claims 1 to 4,
wherein a weight-average molecular weight of the compound containing a support absorptive group and a hydrophilic group is in a range of 5000 to 400000.

6. The planographic printing plate precursor for on-press development according to any one of claims 1 to 5,
wherein the support absorptive group has a structure selected from the group consisting of a phosphoric acid ester structure and a phosphoric acid ester salt structure.

7. A method of preparing a planographic printing plate comprising, in order:
an exposure step of imagewise-exposing the planographic printing plate precursor for on-press development according to any one of claims 1 to 6 to form an exposed portion and an unexposed portion; and
an on-press development step of supplying at least one of a printing ink or dampening water and removing the unexposed portion.

8. A planographic printing method comprising, in order:
an exposure step of imagewise-exposing the planographic printing plate precursor for on-press development according to any one of claims 1 to 6 to form an exposed portion and an unexposed portion;
an on-press development step of supplying at least one of a printing ink or dampening water and removing the unexposed portion; and
a printing step of supplying the printing ink to a planographic printing plate on-press-developed in the on-press development step to print a recording medium.

## Patentansprüche

1. Flachdruckplattenvorläufer für die Entwicklung auf der Presse, umfassend:
einen Aluminiumträger;
eine Zwischenschicht, die eine Verbindung enthält, die eine an den Träger absorptive Gruppe und eine hydrophile Gruppe enthält; und
eine Bildaufzeichnungsschicht auf dem Aluminiumträger, die einen Infrarotabsorber, einen Polymerisationsinitiator, eine polymerisierbare Verbindung und Polymerpartikel, die aus einem Styrol-Copolymer gebildet sind, enthält,
worin der Aluminiumträger eine Aluminiumplatte mit einem anodisierten Film auf einer Oberfläche in Kontakt mit der Zwischenschicht ist und der anodisierte Film Mikroporen aufweist, die sich von einer Oberfläche in Kontakt mit der Zwischenschicht in eine Tiefenrichtung erstrecken,
der mittlere Porendurchmesser der Mikroporen in der Oberfläche des anodisierten Films im Bereich von 20 bis 40 nm liegt und
das Styrol-Copolymer eine Copolymerverbindung von Styrol-(meth)acrylnitril-Poly(ethylenglykol)monoalkylether(meth)acrylat ist,
worin die hydrophile Gruppe eine Struktur aufweist, ausgewählt aus der Gruppe, bestehend aus einer Betainstruktur (Zwitterion), einer Polyalkylenoxystruktur, eine Sulfonsäuregruppe, einer Sulfonatgruppe, einer Carbonsäuregruppe und einer Carboxylatgruppe, und
die an den Träger absorptive Gruppe eine Struktur aufweist, die ausgewählt ist aus der Gruppe bestehend aus einer Phosphonsäurestruktur, einer Phosphonatstruktur, einer Phosphorsäureesterstruktur und einer Phosphorsäureester-Salzstruktur.

2. Flachdruckplattenvorläufer für die Entwicklung auf der Presse gemäß Anspruch 1, worin die hydrophile Gruppe eine Betainstruktur aufweist.

3. Flachdruckplattenvorläufer für die Entwicklung auf der Presse gemäß Anspruch 1 oder 2, worin die Verbindung, die eine an den Träger absorptive Gruppe und eine hydrophile Gruppe enthält, ferner eine polymerisierbare Gruppe enthält.

4. Flachdruckplattenvorläufer für die Entwicklung auf der Presse gemäß irgendeinem der Ansprüche 1 bis 3, worin der zahlengemittelte Partikeldurchmesser der Polymerpartikel im Bereich von 100 bis 300 nm liegt.

5. Flachdruckplattenvorläufer für die Entwicklung auf der Presse gemäß irgendeinem der Ansprüche 1 bis 4, worin das gewichtsgemittelte Molekulargewicht der Verbindung, die einen an den Träger absorptive Gruppe und eine hydrophile Gruppe enthält, im Bereich von 5.000 bis 400.000 liegt.

6. Flachdruckplattenvorläufer für die Entwicklung auf der Presse gemäß irgendeinem der Ansprüche 1 bis 5, worin die an den Träger absorptive Gruppe eine Struktur aufweist, ausgewählt aus der Gruppe, bestehend aus einer Phosphorsäureesterstruktur und einer Phosphorsäureester-Salzstruktur.

7. Verfahren zur Herstellung einer Flachdruckplatte, umfassen in dieser Reihenfolge:
einen Belichtungsschritt zur bildweisen Belichtung des Flachdruckplattenvorläufers für die Entwicklung auf der Presse gemäß irgendeinem der Ansprüche 1 bis 6, um einen belichteten Bereich und einen nicht-belichteten Bereich zu bilden; und
einen Entwicklungsschritt auf der Presse, in dem zumindest eines von Drucktinte oder Anfeuchtwasser zugeführt wird und der unbelichtete Bereich entfernt wird.

8. Flachdruckverfahren, umfassend in dieser Reihenfolge:
einen Belichtungsschritt zur bildweisen Belichtung des Flachdruckplattenvorläufers für die Entwicklung auf der Presse gemäß irgendeinem der Ansprüche 1 bis 6, um einen belichteten Bereich und einen nicht-belichteten Bereich zu bilden;
einen Entwicklungsschritt auf der Presse, in dem zumindest eines von Drucktinte oder Anfeuchtwasser zugeführt wird und der unbelichtete Bereich entfernt wird; und
einen Druckschritt, in dem die Drucktinte zu der Flachdruckplatte zugeführt wird, die in dem Entwicklungsschritt auf der Presse auf der Presse entwickelt worden ist, um ein Aufzeichnungsmedium zu bedrucken.

## Revendications

1. Précurseur de plaque d'impression planographique pour développement sur presse, comprenant :
un support d'aluminium ;
une couche intermédiaire qui contient un composé contenant un groupe absorbant de support et un groupe hydrophile ; et
une couche d'enregistrement d'image qui contient un agent d'absorption infrarouge, un initiateur de polymérisation, un composé polymérisable, et des particules polymères constituées d'un copolymère styrène, sur le support d'aluminium,
dans lequel le support d'aluminium est une plaque d'aluminium ayant un film anodisé sur une surface en contact avec la couche intermédiaire et le film anodisé a des micropores s'étendant dans un sens de profondeur depuis une surface en contact avec la couche intermédiaire,
un diamètre moyen de pore des micropores dans la surface du film anodisé est dans une plage de 20 à 40 nm, et
le copolymère styrène est un copolymère d'un composé de styrène-(méth)acrylonitrile-poly(éthylène glycol)monoalkyléther (méth)acrylate,
le groupe hydrophile a une structure sélectionnée dans le groupe consistant en une structure de bétaïne (zwitterion), une structure de polyalkylèneoxy, un groupe d'acide sulfonique, un groupe de sulfonate, un groupe d'acide carboxylique, et un groupe de carboxylate, et
le groupe absorbant de support a une structure sélectionnée dans le groupe consistant en une structure d'acide phosphonique, une structure de phosphonate, une structure d'ester d'acide phosphorique, et une structure de sel d'ester d'acide phosphorique.

2. Précurseur de plaque d'impression planographique pour développement sur presse selon la revendication 1,
dans lequel le groupe hydrophile a une structure de bétaïne.

3. Précurseur de plaque d'impression planographique pour développement sur presse selon la revendication 1 ou 2,
dans lequel le composé contenant un groupe absorbant de support et un groupe hydrophile contient en outre un groupe polymérisable.

4. Précurseur de plaque d'impression planographique pour développement sur presse selon l'une quelconque des revendications 1 à 3,
dans lequel un diamètre moyen en nombre de particules des particules polymères est dans une plage de 100 à 300 nm.

5. Précurseur de plaque d'impression planographique pour développement sur presse selon l'une quelconque des revendications 1 à 4,
dans lequel un poids moléculaire moyen en poids du composé contenant un groupe absorbant de support et un groupe hydrophile est dans une plage de 5 000 à 400 000.

6. Précurseur de plaque d'impression planographique pour développement sur presse selon l'une quelconque des revendications 1 à 5,
dans lequel le groupe absorbant de support a une structure sélectionnée dans le groupe consistant en une structure d'ester d'acide phosphorique et une structure de sel d'ester d'acide phosphorique.

7. Procédé de préparation d'une plaque d'impression planographique comprenant dans l'ordre :
une étape d'exposition permettant l'exposition sous forme d'image du précurseur de plaque d'impression planographique pour développement sur presse selon l'une quelconque des revendications 1 à 6 pour former une portion exposée et une portion non exposée ; et
une étape de développement sur presse permettant la fourniture d'au moins l'une d'une encre d'impression ou d'une eau de mouillage et l'enlèvement de la portion non exposée.

8. Procédé d'impression planographique comprenant dans l'ordre :
une étape d'exposition permettant l'exposition sous forme d'image du précurseur de plaque d'impression planographique pour développement sur presse selon l'une quelconque des revendications 1 à 6 pour former une portion exposée et une portion non exposée ;
une étape de développement sur presse permettant la fourniture d'au moins l'une d'une encre d'impression ou d'une eau de mouillage et l'enlèvement de la portion non exposée ; et
une étape d'impression permettant la fourniture de l'encre d'impression à une plaque d'impression planographique développée sur presse à l'étape de développement sur presse pour imprimer un support d'enregistrement.
